# EUROPEAN PATENT APPLICATION

(11) **EP 1 930 943 A1**
(43) Date of publication of application: **11.06.2008**
(21) Application number: 06810710.1
(22) Date of filing: 28.09.2006
(51) Int. Cl.: H01L 23/36, H01L 23/473

(54) **HEAT SINK MODULE AND PROCESS FOR PRODUCING THE SAME**

(30) Priority: 28.09.2005 JP 2005282363
(71) Applicant: NGK INSULATORS, LTD., Nagoya-shi, Aichi 467-8530 (JP)
(72) Inventor: SUZUKI, Ken, Nagoya-shi Aichi 4678530 (JP); ISHIKAWA, Takahiro, Nagoya-shi Aichi 4678530 (JP); ISHIKAWA, Shuhei, Nagoya-shi Aichi 4678530 (JP); KUNO, Yumihiko, Nagoya-shi Aichi 4678530 (JP)
(74) Representative: Paget, Hugh Charles Edward
(86) International application number: PCT/JP2006/319261
(87) International publication number: WO 2007/037306

(57) **Abstract**

There is provided a heat sink module having good thermal conductivity, excellent reliability without separation, and a space-saving property with a mechanism of sufficiently high heat radiation. The heat sink module includes: two or more heat conduction sections each having a heat sink layer formed from a heat sink material having a thermal expansion coefficient of 1 × 10⁻⁶/K to 8 × 10⁻⁶/K, an intermediate layer formed from Cu, a Cu alloy, A1, or an A1 alloy, an electrically insulating layer, and an electrode layer formed from said metals, being joined in layers by a first brazing material; and a heat-radiating cooling section 7 having two or more seat surfaces being at least formed from said metals and the two or more heat conduction sections are joined by a second brazing material to seat surfaces with the heat sink layers of heat conduction sections disposed on seat surfaces.

## Description

### Technical Field

The present invention relates to a heat sink module, a method of manufacturing the heat sink module, and an electronic component. More particularly, the present invention relates to a heat sink module for cooling an electronic circuit chip formed of a semiconductor or the like, a method of manufacturing the heat sink module, and an electronic component using the heat sink module.

### Background Art

Generally, heat is the archenemy of a semiconductor device and must be controlled so that an internal temperature of the semiconductor device does not exceed an allowable maximum temperature. In the case of a semiconductor device having large power consumption per unit operating-area, such as a power transistor or a semiconductor rectifier, the quantity of heat released from a casing (package) and leads of the semiconductor device is less than the quantity of heat to be generated, thus involving risk of thermal breakdown associated with a rise in internal temperature of the semiconductor device. This phenomenon can also arise in the semiconductor device of a CPU. Furthermore, since the quantity of heat to be generated during operation increases with a clock frequency of the CPU, thermal design of the CPU must consider heat release.

In practice of thermal design for preventing thermal breakdown or a like problem of a semiconductor device, element design and packaging design involve attachment of a heat sink, which has a large heat radiation area, to a casing (package) of a semiconductor device. A metal material having high thermal conductivity, such as copper or aluminum, is used to form a heat sink.

Conventionally, a difference in coefficient of thermal expansion between a semiconductor substrate (including a semiconductor element and an electrically insulative substrate) and a heat sink is apt to raise the following problems: separation or mechanical breakdown of component members (layers) of a semiconductor device and malfunction of a semiconductor element. These problems become more likely to arise with an increase in the size of a semiconductor device, since stress induced by a difference in coefficient of thermal expansion between component members (layers) increases with the size of a semiconductor device.

In order to solve the above problems, various kinds of heat sink materials have been developed. Specifically, in consideration of achievement of high thermal conductivity and a balance between thermal conductivity and coefficient of thermal expansion, use, as a heat sink material, of a composite material of carbon and metal, such as copper or aluminum, is disclosed (see, e.g., Patent Document 1).

Next will be described a structure of a conventional heat radiation mechanism (heat sink module) which uses, as a heat sink material, a composite material of carbon (C) and copper (Cu) (C/Cu composite material) or a composite material of carbon (C) and aluminum (Al) (C/A1 composite material) (see, e.g., Patent Document 2). FIG. 10 is a sectional view showing an embodiment of a conventional heat sink module. A heat sink module 50 is configured as follows. An intermediate layer 22 formed from a metal material, an electrically insulating layer 23 formed from ceramic, and an electrode layer 24 are arranged in layers on a heat sink layer 51 which is formed from a heat sink material such that adjacent layers are joined together by means of a bonding material 28 such as a brazing material. The heat sink module 50 is fixed on a heat-radiating, cooling mechanism (not illustrated) for radiating heat to the exterior thereof, by means of screws or the like while the heat sink layer 51 abuts the heat-radiating, cooling mechanism. An electronic circuit chip (not illustrated) is fixed on the electrode layer 24 via a solder layer.

Heat generated in the electronic circuit chip is transmitted to the heat-radiating, cooling mechanism via the electrode layer 24, the electrically insulating layer 23, the intermediate layer 22, and the heat sink layer 51 and is then released to the exterior of the heat-radiating, cooling mechanism. However, since the heat sink layer 51 and the heat-radiating, cooling mechanism are joined together merely by means of screws or the like, heat conduction to the heat-radiating, cooling mechanism may be insufficient. In the case where the heat sink layer 51 and the heat-radiating, cooling mechanism are joined together by the use of an appropriate bonding material so as to achieve sufficient heat conduction from the heat sink layer 51 to the heat-radiating, cooling mechanism, a difference therebetween in coefficient of thermal expansion may raise a problem of, for example, separation or damage. Thus, demand has been rising for development of a heat sink module which performs sufficient heat conduction, is unlikely to raise a problem of separation or the like, and provides excellent reliability.

Large-scale integration of elements and an increase in element formation area have led to an increase in the size of a semiconductor device, thereby raising a problem of difficulty in mounting a number of semiconductor elements in a limited space. In order to solve such a problem, demand has been rising for development of an electronic component which is space-saving while exhibiting sufficiently high heat radiation.
[Patent Document 1] JP-A-2001-339022
[Patent Document 2] JP-A-2002-43482

### Summary of the Invention

The present invention has been accomplished in view of the above problems, and an object of the present invention is to provide a heat sink module which exhibits good thermal conductivity, provides excellent reliability through unlikelihood of a problem of separation or the like, and is space-saving while exhibiting sufficiently high heat radiation.

The present inventors have carried out extensive studies, and as a result, have found that the above object could be achieved by means of brazing two or more heat conduction sections to a heat-radiating cooling section, each heat conduction section having a predetermined stacked structure in which adjacent layers are brazed together, and the heat-radiating cooling section being formed from Cu or the like and having two or more mounting surfaces. On the basis of the findings, the present invention has been accomplished.

That is, according to the present invention, there are provided a heat sink module, a manufacturing method thereof, and an electronic component as shown below.

[1] A heat sink module comprising:
two or more heat conduction sections, each comprising a heat sink layer formed from a heat sink material having a coefficient of thermal expansion of 1 × 10⁻⁶/K to 8 × 10⁻⁶/K, an intermediate layer formed from Cu, a Cu alloy, Al, or an Al alloy, an electrically insulating layer, and an electrode layer formed from Cu, a Cu alloy, Al, or an Al alloy, and the heat sink layer, the intermediate layer, the electrically insulating layer, and the electrode layer being joined together in layers by means of a first brazing material; and
a heat-radiating cooling section having two or more seat surfaces;
wherein at least the seat surfaces of the heat-radiating cooling section are formed from Cu, a Cu alloy, Al, or an Al alloy;
the two or more heat conduction sections are joined, by means of a second brazing material, to the corresponding two or more seat surfaces of the heat-radiating cooling section with a state that each of the heat sink layers is disposed on the respective seat surfaces; and
the heat-radiating cooling section includes a flow path through which a cooling medium flows.

[2] A heat sink module according to the above [1], wherein a surface or a bonding face with the second blazing material of the electrode layer is plated with Ni for good solderability.

[3] A heat sink module comprising:
two or more heat conduction sections, each comprising a heat sink layer formed from a heat sink material having a coefficient of thermal expansion of 1 × 10⁻⁶/K to 8 × 10-⁶/K, an intermediate layer formed from Cu, a Cu alloy, Al, or an Al alloy, an electrically insulating layer, an electrode layer formed from Cu, a Cu alloy, Al, or an Al alloy, and an under layer formed from Cu, a Cu alloy, Al, or an Al alloy, and the heat sink layer, the intermediate layer, the electrically insulating layer, the electrode layer, and the under layer being joined together in layers by means of a first brazing material; and
a heat-radiating cooling section having two or more seat surfaces;
wherein at least the seat surfaces of the heat-radiating cooling section are formed from Cu, a Cu alloy, A1, or an A1 alloy;
the two or more heat conduction sections are joined, by means of a second brazing material, to the corresponding two or more seat surfaces of the heat-radiating cooling section with a state that each of the heat sink layers is disposed on the respective seat surfaces; and
the heat-radiating cooling section includes a flow path through which a cooling medium flows.

[4] A heat sink module according to the above [3], wherein at least one of a surface of the electrode layer and a surface of the under layer is plated with Ni for good solderability.

[5] A heat sink module according to the above [2] or [4], wherein the Ni plate has a thickness of 2 µm or more.

[6] A heat sink module according to any one of the above [1] to [5], wherein the heat conduction sections have a thermal conductivity of above 200 W/mK or a thermal resistance of 0.03 K/W or less, and the heat conduction sections have a thermal conductivity of above 200 W/mK or a thermal resistance of 0.12 K/W or less in a portion including a heat-radiating, cooling plate (portion up to a shortest distance to the cooling medium).

[7] A heat sink module according to any one of the above [1] to [5], wherein the heat conduction sections have a thermal conductivity of above 230 W/mK or a thermal resistance of 0.025 K/W or less, and the heat conduction sections have a thermal conductivity of above 230 W/mK or a thermal resistance of 0.09 K/W or less in a portion including a heat-radiating, cooling plate (portion up to a shortest distance to the cooling medium).

[8] A heat sink module according to any one of the above [1] to [7], wherein the heat sink layers of the heat conduction sections have a thickness of 1mm or more, and each of the heat conduction sections has a volume of 12000 mm³ or less.

[9] A heat sink module according to claim any one of the above [1] to [8], wherein the flow path of the heat-radiating cooling section has an inner wall surface assuming the form of recesses and projections.

[10] A heat sink module according to any one of the above [1] to [9], wherein a meshy member is disposed in the flow path of the heat-radiating cooling section.

[11] A heat sink module according to any one of the above [1] to [10], wherein the heat sink material is a material comprising SiC, Si₃N₄, A1N, BeO, BN, or C or a composite material obtained by impregnating a base material of SiC, Si₃N₄, AlN, BeO, BN, or C with Cu, a Cu alloy, Al, or an Al alloy.

[12] A heat sink module according to the above [11], wherein the base material is a porous body.

[13] A heat sink module according to any one of the above [1] to [12], wherein the first brazing material and the second brazing material contain one or more elements belonging to Group 2A, 3A, 4A, 5A, or 4B of the Periodic Table.

[14] A heat sink module according to any one of the above [1] to [13], wherein the electrically insulating layer is formed from AlN or Si₃N₄.

[15] A heat sink module according to any one of the above [1] to [14], wherein portions of the heat-radiating cooling section associated with the seat surfaces each have a thin-walled portion and a thick-walled portion; and
the thin-walled portion has a thickness of 0.1 mm or more.

[16] A method of manufacturing a heat sink module, comprising the steps of:
forming two or more heat conduction sections, each being formed by joining together in layers, by means of a first brazing material, a heat sink layer formed from a heat sink material having a coefficient of thermal expansion of 1 × 10⁻⁶/K to 8 × 10⁻⁶/K, an intermediate layer formed from Cu, a Cu alloy, Al, or an Al alloy, an electrically insulating layer, and an electrode layer formed from Cu, a Cu alloy, Al, or an Al alloy; and
joining, by means of a second brazing material, the two or more heat conduction sections to a heat-radiating cooling section which has two or more seat surfaces, in which at least the seat surfaces are formed from Cu, a Cu alloy, Al, or an Al alloy, and which includes a flow path through which a cooling medium flows; with a state that each of the heat sink layers of the heat conduction sections is disposed on the corresponding two or more seat surfaces.

[17] A method of manufacturing a heat sink module according to the above [16], wherein a surface of the electrode layer is plated with Ni for good solderability.

[18] A method of manufacturing a heat sink module, comprising the steps of:
forming two or more heat conduction sections, each being obtained by joining together in layers, by means of a first brazing material, a heat sink layer formed from a heat sink material having a coefficient of thermal expansion of 1 × 10⁻⁶/K to 8 × 10⁻⁶/K, an intermediate layer formed from Cu, a Cu alloy, Al, or an Al alloy, an electrically insulating layer, an electrode layer formed from Cu, a Cu alloy, Al, or an Al alloy, and an under layer formed from Cu, a Cu alloy, Al, or an Al alloy; and
joining, by means of a second brazing material, the two or more heat conduction sections to a heat-radiating cooling section which has two or more seat surfaces, in which at least the seat surfaces are formed from Cu, a Cu alloy, A1, or an A1 alloy, and which includes a flow path through which a cooling medium flows; with a state that each of the heat sink layers of the heat conduction sections is disposed on the corresponding two or more seat surfaces.

[19] A method of manufacturing a heat sink module according to the above [18], wherein at least one of a surface of the electrode layer and a surface of the under layer is plated with Ni for good solderability.

[20] A method of manufacturing a heat sink module according to the above [17] or [19], wherein the Ni plate has a thickness of 2 µm or more.

[21] A method of manufacturing a heat sink module according to any one of the above [16] to [20], wherein the heat conduction sections have a thermal conductivity of above 200 W/mK or a thermal resistance of 0.03 K/W or less, and the heat conduction sections have a thermal conductivity of above 200 W/mK or a thermal resistance of 0.12 K/W or less in a portion including a heat-radiating, cooling plate (portion up to a shortest distance to the cooling medium).

[22] A method of manufacturing a heat sink module according to any one of the above [16] to [20], wherein the heat conduction sections have a thermal conductivity of above 230 W/mK or a thermal resistance of 0.025 K/W or less, and the heat conduction sections have a thermal conductivity of above 230 W/mK or a thermal resistance of 0.09 K/W or less in a portion including a heat-radiating, cooling plate (portion up to a shortest distance to the cooling medium).

[23] A method of manufacturing a heat sink module according to any one of the above [16] to [22], wherein the heat sink layers of the heat conduction sections have a thickness of 1mm or more, and each of the heat conduction sections has a volume of 12000 mm³ or less.

[24] A method of manufacturing a heat sink module according to any one of the above [16] to [23], wherein the first brazing material and the second brazing material contain one or more elements belonging to Group 2A, 3A, 4A, 5A, or 4B of the Periodic Table.

[25] A method of manufacturing a heat sink module according to any one of the above [16] to [24], further comprising the step of arranging a plurality of plate-like members in layers and joining the plate-like members together by means of a third brazing material so as to yield the heat-radiating cooling section having a flow path formed therein through which a cooling medium flows.

[26] A method of manufacturing a heat sink module according to the above [25], wherein, among the plate-like members, the plate-like members other than those encompassing the seat surfaces are lower in coefficient of thermal expansion than those encompassing the seat surfaces.

[27] A method of manufacturing a heat sink module according to any one of the above [16] to [26], wherein the heat sink material is a material comprising SiC, Si₃N₄, A1N, BeO, BN, or C or a composite material obtained by impregnating a base material of SiC, Si₃N₄, AlN, BeO, BN, or C with Cu, a Cu alloy, Al, or an Al alloy.

[28] A method of manufacturing a heat sink module according to the above [27], wherein the base material is a porous body.

[29] A method of manufacturing a heat sink module according to any one of the above [16] to [28], wherein the electrically insulating layer is formed from AlN or Si₃N₄.

[30] A method of manufacturing a heat sink module according to the above [29], wherein insulation ability is secured by subjecting a surface of the electrically insulating layer formed from AlN or Si₃N₄ to a blasting or etching treatment.

[31] An electronic component comprising:
a heat sink module as recited in any one of the above [1] to [15]; and
two or more electronic circuit chips disposed, via respective solder layers, on the respective electrode layers of the two or more heat conduction sections of the heat sink module.
[32] An electronic component according to the above [31], wherein the solder layers are made of lead-free solder.

### Effect of the Invention

A heat sink module of the present invention has good heat conduction, excellent reliability through unlikelihood of a problem of separation or the like, and space-saving with sufficiently high heat radiation.
In addition, according to a method of manufacturing a heat sink module of the present invention, there is provided a heat sin module having good heat conduction, excellent reliability through unlikelihood of a problem of separation or the like, and space-saving with sufficiently high heat radiation.

The electronic component of the present invention exhibits an effect in having good heat conduction, excellent reliability through unlikelihood of a problem of separation or the like, and space-saving with sufficiently high heat radiation.

### Brief Description of the Drawings

[FIG. 1] FIG. 1 is a sectional view showing an embodiment of a heat sink module of the present invention;
[FIG. 2] FIG. 2 is a sectional view showing another embodiment of a heat sink module of the present invention;
[FIG. 3] FIG. 3 is a sectional view showing still another embodiment of a heat sink module of the present invention;
[FIG. 4] FIG. 4 is a sectional view showing a further embodiment of a heat sink module of the present invention;
[FIG. 5] FIG. 5 is a sectional view schematically showing an embodiment of a method of manufacturing a heat sink module of the present invention;
[FIG. 6] FIG. 6 is a sectional view schematically showing another embodiment of a method of manufacturing a heat sink module of the present invention;
[FIG. 7] FIG. 7 is a sectional view schematically showing a method of manufacturing a heat conduction section having an under layer disposed thereon;
[FIG. 8] FIG. 8 is a sectional view schematically showing still another embodiment of a method of manufacturing a heat sink module of the present invention;
[FIG. 9] FIG. 9 is an enlarged sectional view showing a C/Cu composite material;
[FIG. 10] FIG. 10 is a sectional view showing an embodiment of a conventional heat sink module;
[FIG. 11] FIG. 11 is a sectional view showing another embodiment of a heat sink module of the present invention;
[FIG. 12] FIG. 12 is a sectional view showing another embodiment (embodiment where a heat conduction section of FIG. 11 is joined to a heat-radiating cooling section) of a heat sink module of the present invention;
[FIG. 13] FIG. 13 is a sectional view showing another embodiment (embodiment where a heat conduction section of FIG. 7 is joined to a heat-radiating cooling section) of a heat sink module of the present invention; and
[FIG. 14] FIG. 14 is a sectional view showing another embodiment of a conventional heat sink module.

### Description of Reference Numerals

1, 51: heat sink layer, 2, 22: intermediate layer, 3, 23: electrically insulating layer, 4, 24: electrode layer, 5a, 5b, 5c, 5d, 5e: heat conduction section, 6, 16, 26, 36: flow path, 7, 17, 27, 37: heat-radiating cooling section, 8: projection portion, 9: meshy member, 10, 20, 30, 40, 50: heat sink module, 11, 21, 31, 41: electronic component, 12: thin-walled portion, 13: thick-walled portion, 15: first brazing material, 25: second brazing material, 28: bonding material, 35: third brazing material, 45: seat surface, 65: under layer, 60, 70, 75, 80: metal plate, 100: IC chip, 110: solder layer, 120: C/Cu composite material, 130: porous sintered body, 140: open pore, 150: Cu or Cu alloy

### Best Mode for Carrying Out the Invention

The best mode of the present invention will next be described in detail with reference to the drawings. However, the present invention is not limited thereto. It is to be understood by those skilled in the art that variations and modifications thereof are possible without departing from the spirit and scope of the invention. The order of arrangement of layers, the thickness of individual layers, and the like are determined as appropriate on the basis of thermal conductivity, coefficient of thermal expansion, Young's modulus, and the like of materials.

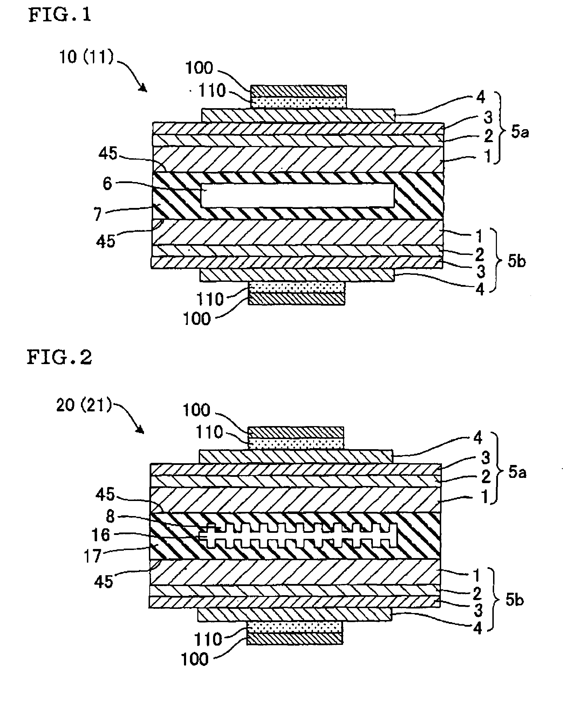

FIG. 1 is a sectional view showing an embodiment of the heat sink module of the present invention. As shown in FIG. 1, a heat sink module 10 of the present embodiment includes two heat conduction sections 5a and 5b and a heat-radiating cooling section 7 having two seat surfaces 45. Each of the heat conduction sections 5a and 5b is configured such that a heat sink layer 1, an intermediate layer 2, an electrically insulating layer 3, and an electrode layer 4 are arranged in layers in this order and are joined together by means of a first brazing material. Incidentally, a surface of the electrode layer 4 is plated with Ni in order to make joining (soldering, or the like) to an electronic circuit easy (not illustrated, the same for all the following embodiments). By having a heat-radiating, cooling plate, the order of arrangement of the layers shown in FIG. 1 is a mere example. The order of arrangement of layers of a heat sink module according to the present invention is not limited thereto.

The heat sink layer 1 is formed from a heat sink material having a coefficient of thermal expansion of 1 × 10⁻⁶/K to 8 × 10⁻⁶/K, preferably 2 × 10⁻⁶/K to 6 × 10⁻⁶/K, more preferably 3 × 10⁻⁶/K to 5 × 10⁻⁶/K. When the coefficient of thermal expansion of a heat sink material is less than 1 × 10⁻⁶/K, thermal stress arises, possibly leading to breakdown in a thermal test. When the coefficient of thermal expansion of a heat sink material is in excess of 8 × 10⁻⁶/K, thermal stress arises, possibly leading to breakdown in a thermal test.

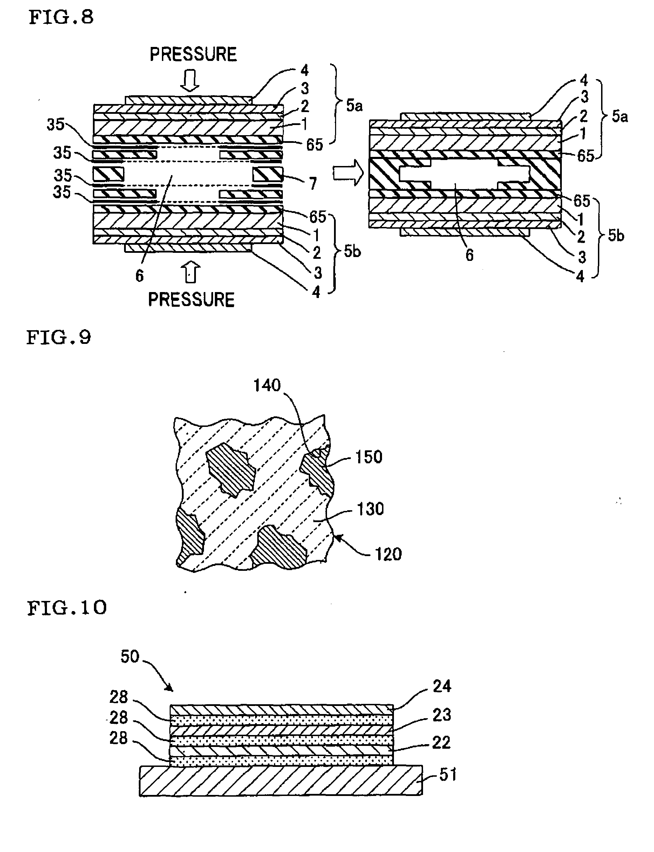

No particular limitation is imposed on the type of a heat sink material so long as coefficient of thermal expansion thereof falls within the above-mentioned ranges. The heat sink material is preferably of SiC, Si₃N₄, AlN, BeO, BN, or C as it is or a composite material obtained by impregnating a base material of SiC, Si₃N₄, AlN, BeO, BN, or C with Cu or a Cu alloy (e.g., C/Cu composite material) or impregnating the base material with Al or an Al alloy (e.g., C/A1 composite material). As shown in FIG. 9, a C/Cu composite material is obtained by impregnating open pores 52 of a porous sintered body (porous body) 50 with molten Cu or Cu alloy 54 and then allowing the Cu or Cu alloy 54 to solidify. The porous sintered body 50 is obtained by forming a network structure of carbon or its allotrope through pre-firing. The details of the C/Cu composite material are described in, for example, Japanese Patent Application Laid-Open (*kokai*) No. 2001-339022. The C/Al composite material also has a structure similar to that of the C/Cu composite material shown in FIG. 9. Specifically, the C/A1 composite material is obtained by impregnating open pores of a porous sintered body (porous body) with molten Al or A1 alloy and allowing the Al or Al alloy to solidify. Since the C/Cu composite material and the C/A1 composite material are considerably low in Young's modulus, residual stress is unlikely to arise after joining. Accordingly, the electrically insulating layer 3 becomes unlikely to crack and to separate. In the case of using a composite material, the network-forming base material acts as a matrix and suppresses thermal expansion of the metal with which the base material is impregnated. Therefore, the material has the advantage of smaller thermal expansion than that obtained from stoichiometry, and enhanced heat conductivity of the network-forming matrix.

Examples of a base material include porous bodies such as the porous sintered body 130 shown in FIG. 9. Porous bodies conceptually include those materials which are formed by compacting powder, particles, fillers, or the like and have pores connected in a network fashion, as well as general porous bodies.

Preferably, the thermal conductivity of a heat sink material used to form the heat sink layer 1 is 150 W/mK or more. When the thermal conductivity is less than 150 W/mK, thermal conductivity of a heat conduction section does not exceed 200 W/mK, or thermal resistance is not below 0.03 K/W, further the thermal resistance does not exceed a thermal conductivity of 230 W/m, which is a desirable range, and thermal resistance is not below 0.025 K/W. By this, the rate of transmission to the exterior of an electronic component 11 of heat which an IC chip 100 generates in association with use of the electronic component 11 drops. Thus, maintaining the IC chip 100 at a constant temperature tends to become difficult. In the case where the heat sink material used to form the heat sink layer 1 is a single substance of C or SiC or the above-mentioned C/Cu or C/Al composite material or the like, the coefficient of thermal expansion and the thermal conductivity thereof can be controlled so as to fall within the above-mentioned respective ranges, by means of adjusting percentage composition thereof in terms of components. This aims at the effect of suppressing thermal expansion of the metal with which the matrix (SiC, Si₃N₄, AlN, BeO, Bn, or C) is impregnated by the ceramic of the network-forming matrix particularly in the case of a composite material.

Dimensions of the heat sink layer 1 are determined with consideration for strength for fixation to the heat-radiating cooling section 7 and for sufficient transmission of heat generated in an electronic circuit chip, such as the IC chip 100, disposed on the electrode layer 30. Specifically, the thickness of the heat sink layer 1 is preferably 1 mm to 30 mm. It is needless to say that the thickness is determined in consideration of thermal conductivity, thermal resistance, and a stress relaxation effect. When the heat sink layer 1 is too thin, it cannot withstand stress generated in an electrode, a solder for bonding an electronic circuit, an intermediate layer, in an under layer, and between heat-radiating, cooling plates. When a heat sink layer is too thick, miniaturization is hardly realized, and thermal resistance increases. In order to realize a small-sized heat sink module having excellent heat-radiation ability, the heat conduction section desirably has a volume of 12000 mm³ or less. When it is above 12000 mm³, a module becomes large as a whole, and it does not contribute to miniaturization.

The intermediate layer 2 can mitigate a difference in thermal expansion between the electrically insulating layer 3 and the heat sink layer 1 at the time of thermal shock and is formed from Cu, a Cu alloy, Al, or an Al alloy. Provision of the intermediate layer 2 improves an overall joining property of the heat sink module 10 and resistance to thermal shock. The thickness of the intermediate layer 2 is preferably 0.05 mm to 3.0 mm, more preferably 0.05 mm to 1.0 mm. Even when the intermediate layer 2 is thin, the intermediate layer 2 yields the effect of mitigating a difference in thermal expansion between the electrically insulating layer 3 and the heat sink layer 1. However, imparting the same influence including volume ratio to the upside and the downside of the electrically insulating layer 3 in consideration of volume of the intermediate layer 2 (considering the influence of the coefficient of thermal expansion and the volume) attains a good balance between the upside and the downside of the electrically insulating layer 3.

The electrically insulating layer 3 is formed from a material capable of electrically insulating the electrode layer 4 and the intermediate layer 2 from each other; for example, AlN or Si₃N₄. In the case where AlN or SiN₄ is used to form the electrically insulating layer 3, the coefficient of thermal expansion of the electrically insulating layer 3 becomes substantially identical with that of an electronic circuit chip such as the IC chip 16. The minimum thickness of the electrically insulating layer 3 is determined so as to establish electric insulation against current flowing in the electrode layer '4. However, in actuality, the minimum thickness is determined from strength, since the electrically insulating layer 3 is formed from a material which is more fragile as compared with other layers. The maximum thickness of the electrically insulating layer 3 is determined from thermal resistance. A large thickness is advantageous in terms of strength, but tends to cause a drop in heat conduction as viewed in a circuit. Accordingly, the maximum thickness of the electrically insulating layer 3 is preferably 0.1 mm to 2.0 mm, more preferably 0.1 mm to 1.0 mm.

It is important to secure an insulation distance so as to establish electric insulation. Concretely, the distance is 2 mm or more, desirably 2.5 mm or more, and more desirably 3 mm or more. Therefore, dimensions of the electrode 4, heat sink layer 1, intermediate layer 2, and the like, are also selected so as to establish electric insulation. In the case that a conductive body or the like adheres to a surface of the electrically insulating layer 3 upon joining, it should be removed by a physical method such as blasting or a chemical method such as etching after the insulating distance is secured.

The electrode layer 4 is formed from Cu, a Cu alloy, Al, or an Al alloy. The minimum thickness of the electrode layer 4 is determined from current density of the electrode layer 4. The maximum thickness is determined from target resistance to thermal shock as measured after joining. The maximum thickness of the electrode layer 4 is preferably 0.05 mm to 2.0 mm, more preferably 0.1 mm to 1.0 mm.

On the other hand, in the case that an under layer 65 is joined as shown in FIG. 8 or the like, it is preferable that the under layer 65 has a thickness similar to that of the electrode layer 4. However, since the under layer 65 is not joined directly with an electronic circuit, the thickness may arbitrarily be determined. It is needless to say that the thickness may be determined in consideration of the fact that, with the thickness, it can pass a thermal shock test (for example, 1000 to 3000 times repeats from -40°C to 150°C) for securing reliability of the module, and a warped shape or the like of a joined body.

At least the seat surfaces 45 of the heat-radiating cooling section 7 are formed from Cu, a Cu alloy, Al, or an Al alloy. Forming the seat surfaces 45 from Cu, a Cu alloy, Al, or an Al alloy allows the heat sink layers 1 and the respective seat surfaces 45 to be joined together by means of a second brazing material under pressure. Notably, the entire heat-radiating cooling section 7 may be formed from Cu, a Cu alloy, Al, or an Al alloy.

As shown in FIG. 1, in the heat sink module 10 of the present embodiment, the two heat conduction sections 5a and 5b are joined to the respective two seat surfaces 45 of the heat-radiating cooling section 7. The heat conduction sections 5a and 5b are joined to the respective seat surfaces 45 by means of the second brazing material with a state that each of the heat sink layers 1 is disposed on the respective seat surfaces 45. By joining the two heat conduction sections 5a and 5b by means of the heat-radiating cooling section 7, the heat sink module becomes symmetric. By this, stress due to a difference in thermal expansion is well balanced, and stress concentration is hardly caused. Therefore, a problem such as separation is unlikely to arise between the seat surfaces 45 of the heat-radiating cooling section 7 and the respective heat sink layers 1, and thus the heat sink module 10 can have excellent reliability. In FIG. 1, heat conduction sections are disposed on the upside and the downside. However, similar effects can be expected even if the heat conduction sections are disposed on the upside, the downside, the right side, and the left side (not illustrated) or.disposed so as to form a hexagon or an octagon (neither is illustrated). Space-saving is also possible by providing an almost spherical heat-radiating cooling section with seat surfaces (to form a shape such as a hexagon, a regular dodecahedron, or a soccer ball shape) (not illustrated). There are some cases that a stress balance can be improved even if the shape is not completely symmetric. Even in the case that a heat-radiating cooling section is disposed only on one side, a suspected stress balance can be improved by controlling thickness on the side where a heat-radiating cooling section is disposed is not disposed. Further, imparting a small angle (for example, making a V shape or an A shape by two heat-radiating cooling sections) is also effective (not illustrated). Also, a single heat-radiating cooling section 7 can have the seat surfaces 45 corresponding to the two or more heat conduction sections 5a and 5b. Accordingly, the heat sink module 10 of the present embodiment allows disposition of a greater number of electronic circuit chips (IC chips 100) in a limited space, thereby exhibiting excellent space-saving.

Preferably, the first brazing material and the second brazing material contain one or more elements (active elements) belonging to Group 2A, 3A, 4A, 5A, or 4B of the Periodic Table. When such a brazing material is used, joining the layers together or the heat-radiating cooling section and the heat sink layers together is performed under pressure. Thus, the thickness of a brazing material can be controlled by adjusting pressure to be applied. As compared with a heat sink module in which a solder layer having a thickness of several hundreds of µm is used to join the layers together, a resultant heat sink module exhibits excellent heat radiation. Even upon exposure to a thermal cycle, thermal shock, or the like, the electrically insulating layer 3 is unlikely to crack or suffer a like problem; thus, thermal reliability can be improved. The average thickness of the first brazing material and the second brazing material as measured after joining is preferably 50 µm or less, more preferably 10 µm or less, most preferably 5 µm or less. This thickness can be controlled by adjusting pressure to be applied.

Specific examples of the first brazing material and the second brazing material include an Ag-Cu-Ti brazing material and an Ag-Cu-In-Ti brazing material. An active metal contained in these brazing material is Ti. The first brazing material and the second brazing material may be identical with or different from each other. In the case where the intermediate layer and the electrode layer are formed from A1 or an Al alloy, it is appropriate to use a brazing material having a low melting point, such as an A1 brazing material, as the first and second brazing materials.

The second brazing material may be the same as the first brazing material, with the same components. When a heat conduction section joined by means of the first brazing material is joined to a heat-radiating cooling section, the second brazing material may be a blazing material (may be solder) having a low melting point and containing Sn, or the like, selected from one or more elements belonging to Group 2A, 3A, 4A, 5A, or 4B of the Periodic Table. In the case that an under layer 65 is provided, a surface of the under layer 65 is plated with Ni, and joining is easy even without pressure. It is possible to apply pressure in order to improve a joining property.

Preferably, a flow path 6 through which a cooling medium flows is formed in the heat-radiating cooling section 7, since heat generated in the IC chip 100 can be more efficiently released to the exterior of the heat sink module 10. FIG. 2 is a sectional view showing another embodiment of a heat sink module of the present invention. Preferably, the heat sink module 20 of the present embodiment is configured as follows: as shown in FIG. 2, projection portions 8 are formed in a flow path 16 of a heat-radiating cooling section 17 such that the inner wall surface of the flow path 16 assumes the form of recesses and projections. By virtue of imparting recesses and projections to the inner wall surface of the flow path 16, a cooling medium such as water which flows in the flow path 16 is likely to become turbulent, and a contact area between the cooling medium and the heat-radiating cooling section 17 increases. Thus, heat generated in the IC chip 100 can be more efficiently released to the exterior of the heat sink module 20. In FIG. 2, reference numeral 21 denotes an electronic component.

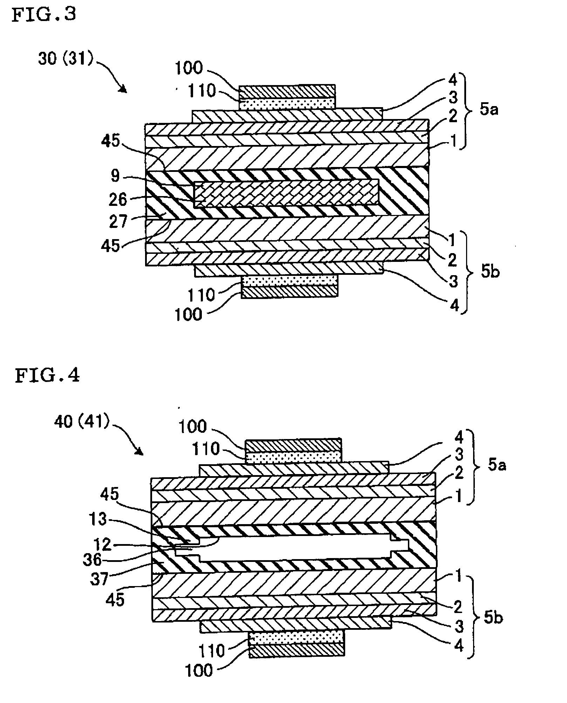

Preferably, a heat sink module 30 of still another embodiment of the present invention is configured such that, as shown in FIG. 3, a meshy member 9 is disposed in a flow path 26 of a heat-radiating cooling section 27. By virtue of disposing the meshy member 9 in the flow path 26, a cooling medium such as water which flows in the flow path 26 is likely to become turbulent. Thus, heat generated in the IC chip 100 can be more efficiently released to the exterior of the heat sink module 30. In FIG. 3, reference numeral 31 denotes an electronic component.

Preferably, a heat sink module 40 of a further embodiment of the present invention is configured such that, as shown in FIG. 4, portions of a heat-radiating cooling section 37 associated with seat surfaces 45 each have a thin-walled portion 12 and a thick-walled portion 13. By virtue of the fact that portions of the heat-radiating cooling section 37 associated with the seat surfaces 45 each have the thin-walled portion 12, the distance between a flow path 36 and the IC chips 100 disposed on the respective electrode layers 4 can be shortened. Thus, heat radiation efficiency can further be improved. In the present embodiment, the thickness of the thin-walled portion 12 is preferably 0.1 mm to 50 mm. A more preferred thickness of the thin-walled portion 12 is determined from heat balance, thermal stress, and weight. Specifically, the thickness is more preferably 0.1 mm to 20 mm, most preferably 0.1 mm to 5 mm. When the thickness of the thin-walled portion 12 is less than 0.1 mm, wear caused by erosion may arise. In FIG. 4, reference numeral 41 denotes an electronic component.

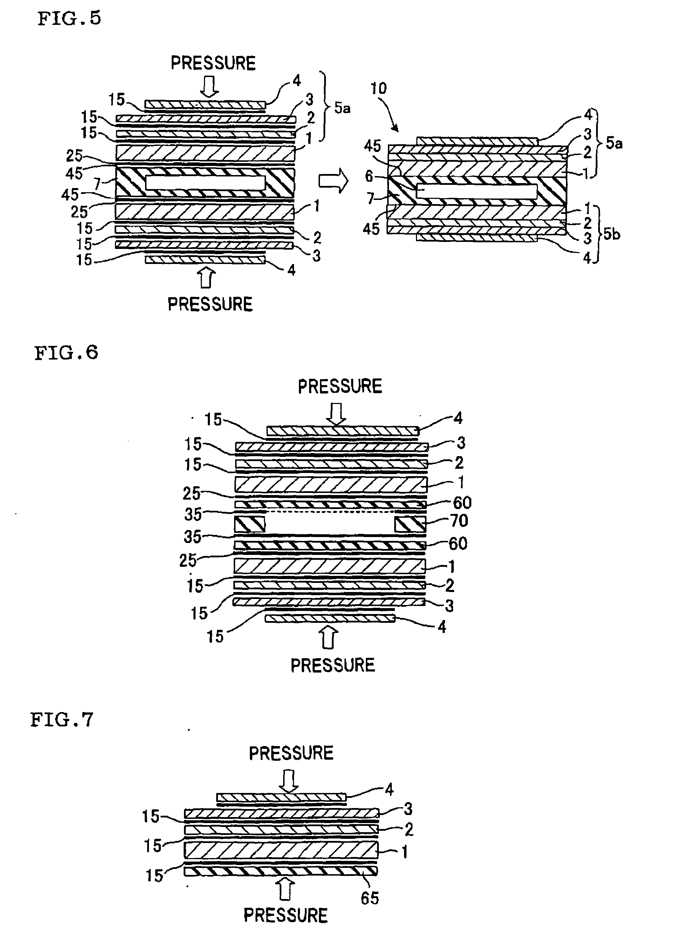

Next, an embodiment of a method of manufacturing a heat sink module of the present invention will be described. FIG. 5 is a sectional view schematically showing the embodiment of a method of manufacturing a heat sink module of the present invention. As shown in FIG. 5, in the method of manufacturing a heat sink module of the present embodiment, the heat sink layer 1, the intermediate layer 2, the electrically insulating layer 3, and the electrode layer 4 are arranged in layers in this order on each of the two seat surfaces 45 of the heat-radiating cooling section 7. At this time, a first brazing material 15 is interposed between the heat sink layer 1, the intermediate layer 2, the electrically insulating layer 3, and the electrode layer 4. A second brazing material 25 is interposed between the heat sink layer 1 and each of the two seat surfaces 45 of the heat-radiating cooling section 7. While a pressure of 0.2 MPa to 10 MPa is applied to the thus-prepared assembly in a vacuum of, for example, about 0.00133 Pa, temperature is raised and then lowered. This procedure yields the heat sink module 10 in which the heat conduction sections 5a and 5b are joined to the corresponding two seat surfaces 45 of the heat-radiating cooling section 7.

As mentioned above, in the method of manufacturing a heat sink module of the present embodiment, the heat sink layer 1, the intermediate layer 2, the electrically insulating layer 3, and the electrode layer 4 are joined together by means of the first brazing material 15, thereby forming each of the heat conduction sections 5a and 5b. Thus, these layers are firmly joined together. Also, in the method of manufacturing a heat sink module of the present embodiment, the second brazing material 25 is used to join the heat-radiating cooling section 7 and each of the heat sink layers 1 together; thus, the heat sink layers 1 are firmly joined to the heat-radiating cooling section 7. Furthermore, since the first brazing material 15 can be made thin by adjusting pressure to be applied, there can be manufactured the heat sink module 10 Whose heat conduction distance is short and whose heat radiation efficiency is excellent.

Generally, each of the electrode layers 4 of the thus-manufactured heat sink module 10 is formed into a desired circuit pattern. Specifically, first, resist used to form a circuit is applied by printing onto the entire surface of the electrode layer 4. The thus-applied resist is selectively hardened such that portions which are not to be etched away are hardened. Subsequently, unhardened portions of the resist are removed so as to partially expose the electrode layer 4. Exposed portions of the electrode layer 4 (e.g., Cu) are etched away by the use of an aqueous solution of cupric chloride, whereby the electrode layer 4 can be formed into a desired pattern. A brazing material exposed between pattern traces can be removed by means of washing with an aqueous solution of ammonium acid fluoride and then with water. Subsequently, a protective layer such as an Ni-P plating layer may be formed on the surface of the pattern.
On the other hand, there are some cases of using it without forming a circuit. In this case, an electronic circuit is directly joined on a joined electrode surface by soldering. In this case, it is better to join the electrode layer 4 plated with Ni in advance. Of course, there is no problem even if plating is conducted after joining. Particularly, in the case of not forming a circuit pattern, joining is performed so that the insulating layer 3 rather than the electrode layer 4 can secure a predetermined insulation distance in order to secure an insulation distance as shown in Examples in and after FIG. 1. In the case of forming a circuit pattern, a pattern with which a predetermined insulation distance can be secured may be formed. In this case, the electrode layer 4 and the insulating layer 3 may have the same dimensions upon joining.

As mentioned previously, at least the seat surfaces of the heat-radiating cooling section are formed from Cu, a Cu alloy, Al, or an Al alloy. However, in the case where pressure distribution arises at the time of application of pressure in the course of joining by means of a brazing material, unjoined portions where joining is incomplete may be formed. When, in order to avoid occurrence of unjoined portions, pressure to be applied is increased, the seat surfaces of the heat-radiating cooling section may be softened and deformed. Thus, preferably, at least the seat surfaces of the heat-radiating cooling section are formed from CuCr or the like, which exhibits excellent high-temperature strength as compared with Cu and is of high heat-conduction, since occurrence of unjoined portions can be avoided while excellent heat conduction is maintained.

Preferably, in order to avoid pressure distribution which would otherwise arise at the time of application of pressure in the course of joining by means of a brazing material, a cushion insert is interposed together with a brazing material. Examples of a cushion insert include a carbon sheet, paper, a metal sheet, and a ceramic plate. The thickness of the insert is preferably 0.1 mm to 10 mm.

In the method of manufacturing a heat sink module of the present embodiment, as shown in FIG. 6, the heat-radiating cooling section 7 (see FIG. 1) having the flow path 6 (see FIG. 1) formed therein through which a cooling medium flows may be formed by arranging a plurality of plate-like members; i.e., metal plates 60 and 70, in layers and joining the plate-like members together by means of a third brazing material 35. In the case where the heat-radiating cooling section is formed by arranging a plurality of plate-like members in layers and joining the plate-like members together, forming the flow path, forming the heat conduction sections, and joining together the heat conduction sections and the heat-radiating cooling section can be completed by a single joining operation, thereby simplifying a manufacturing process. The third brazing material 35 can be similar to the aforementioned first and second brazing materials (brazing materials containing a predetermined active element).

Preferably,' among the plate-like members; i.e., the metal plates 60 and 70 shown in FIG. 6, the plate-like member (metal plate 70) other than those (metal plates 60) encompassing the seat surfaces is lower in coefficient of thermal expansion than those (metal plates 60) encompassing the seat surfaces. Heat generated in the IC chips or the like to be disposed on the respective electrode layers 4 is not directly transmitted to the metal plate 70. Therefore, the metal plate 70 can have a coefficient of thermal expansion lower than that of the metal plates 60. For example, when thin heat sink layers are employed, this can avoid a problem of cracking in the heat sink layers. When the metal plates 60 are, for example, Cu plates, the metal plate 70 is preferably of, for example, CuW or CuMo, whose coefficient of thermal expansion is lower than that of Cu. A plate-like member employed in FIG. 6 is of metal; i.e., the metal plate 70. Material for the plate-like member is not limited to metal, but may be, for example, alumina or Si₃N₄.

Next, the method of manufacturing the heat sink module 40 shown in FIG. 4 will be described. In manufacture of the heat sink module 40, for example, as shown in FIG. 7, a metal plate 65 serving as an under layer which is of, for example, Cu is placed on an appropriate jig (not illustrated). The heat sink layer 1, the intermediate layer 2, the electrically insulating layer 3, and the electrode layer 4 are arranged in layers in this order on the under layer 65. At this time, the first brazing material 15 is interposed between them. Particularly, the second brazing material may be interposed between the heat sink layer 1 and the metal plate 65. While a pressure of 0.2 MPa to 10 MPa is applied to the thus-prepared assembly in an appropriate vacuum, temperature is raised and then lowered. By this procedure, the heat conduction sections 5a and 5b which are each backed with the metal plate 65 can be manufactured. Next, as shown in FIG. 8, the thus-manufactured heat conduction sections 5a and 5b and metal plates 75 and 80 having respectively predetermined shapes are arranged in layers with a state that the third brazing material 35 is interposed therebetween. One may produce a heat sink module 40 whose cooling section with the heat-radiation cooling section 37 has a thin walled portion 12 and a thick walled portion 13 in the portion corresponding to the seat surfaces 45 by applying a pressure of 0.2 MPa to 10 MPa to the thus-prepared assembly in an appropriate vacuum, with raising and lowing temperature.

Preferably, the melting point of the third brazing material 35 used to join the metal plates 75 and 80 together and to join the heat conduction sections 5a and 5b and the corresponding metal plates 75 together is lower than those of the first brazing material 15 and the second brazing material 25 (see FIG. 7) used to manufacture the heat conduction sections 5a and 5b. Use of a third brazing material whose melting point is lower than those of first and second brazing materials avoids the risk of melting of the first and second brazing materials when temperature is raised for manufacturing a heat sink module by the use of the third brazing material. Thus, deformation or a like problem is unlikely to arise in the course of manufacture of a heat sink module. Therefore, a highly reliable heat sink module can be manufactured.

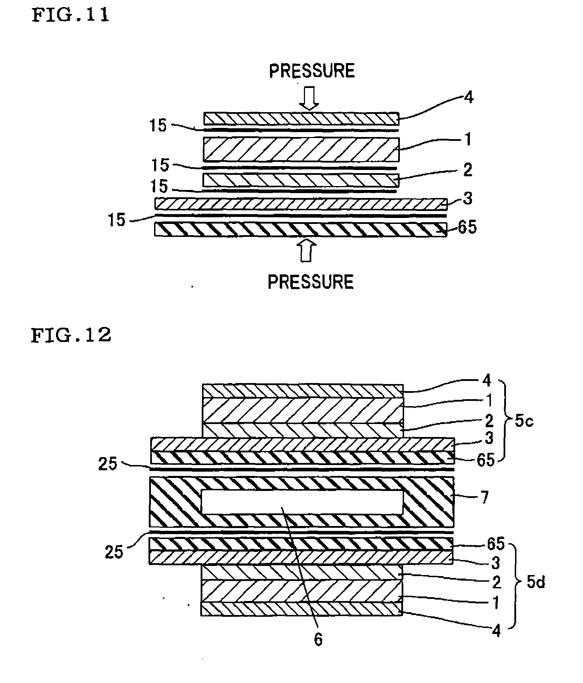

FIG. 11 shows an embodiment where a stacked structure is changed. An intermediate layer 2, a heat sink layer 1, and an electrode layer 4 are arranged in the upper portion of the insulating layer 3. This structure can secure a heat capacity for storing heat generated on the electrode layer 4. In this stacked structure, it is necessary to provide an under layer 65, and plating with Ni may be performed for joining the under layer 65 to the heat-radiating cooling section 7 though it is not necessary.

FIG. 12 shows an embodiment where the heat conduction sections 5c, 5d joined in FIG. 11 are joined to the heat-radiating cooling section 7 by means of the second blazing material. It is not always necessary to apply pressure depending on kind and thickness of the blazing material.

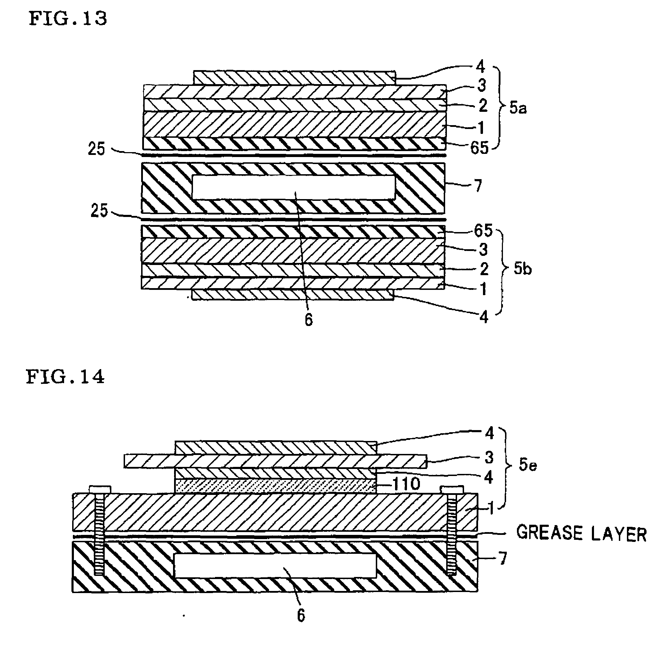

FIG. 13 shows an embodiment where the heat conduction sections 5c, 5d joined in FIG. 7 are joined to the heat-radiating cooling section 7 by means of the second blazing material. It is not always necessary to apply pressure depending on kind and thickness of the blazing material.

It has already been described that there are some stacked structures other than those illustrated. There can be considered a method where a plating treatment is applied or not applied on the under layer 65, a method of simultaneous joining with the heat-radiating cooling section 7, or a method of joining with the heat-radiating cooling section 7 after the layers are stacked. At that time, conditions for a non-pressurizing method or a pressurizing method is selected in consideration of selection of a blazing material, quality of a heat sink material, size, thickness of each layer, conditions due to manufacturing equipment, and the like.
FIG. 14 shows an embodiment of a module used for a hybrid car on the market at present. A substrate (three layer structure of aluminum, aluminum nitride, and aluminum) 72 is joined to a CuMo heat sink material 1 by a solder 70.

### Examples

Examples of the present invention will hereinbelow be described.
Tables 1 to 4 each show a difference between a theoretical value and a practical value with respect to an embodiment having each structure with employing the heat conductive section 5e shown in FIG. 14 as a bench mark (standard).

Table 1 shows the results of the Example 1 in the case that specific materials and dimensions are employed in the heat conduction section 5a or 5b in the heat sink module shown in FIG. 1. Similarly, Table 2 shows the results of the Example 2 in the case that specific materials and dimensions are employed in the heat conduction section 5a or 5b in the heat sink module shown in FIG. 13. Table 3 shows the results of Example 3 in the case that specific materials and dimensions are employed for the heat conduction section shown in FIG. 11. Table 4 shows the results of the standard example (Comparative Example 1) in the case that an article in circulation in the market at present is employed for the heat conduction section 5e in the heat sink module shown in FIG. 14. Table 5 collectively shows Examples 1 to 3 and Comparative Example 1 of the heat conductive section.

In each of.Examples 1 to 3, thermal conductivity is above 200 W/mk and above 230 W/mk, which is the more desirable range, and there is little difference from the theoretical value. The thermal resistance is below 0.03 K/W and below 0.025 K/W. This shows a good joining property. On the other hand, a heat capacity up to a substrate is compared. An amount of this heat capacity shows an extent of storing the heat until heat is transmitted after quick heat generation of IGBT or the like is caused. Though Examples 1 and 2 each have a worse heat capacity than Comparative Example 1, Example 3 has a very high heat capacity. In the case that the heat-radiating cooling section 7 uses a medium such as cooling with water, an amount of the heat capacity is not a serious problem. However, in the case of air or the like, one having larger heat capacity is more advantageous because the heat-taking ability is lower than water or the like. It is selected depending on performance of the heat-radiating cooling section 7 and a heat-radiating, cooling method.

Further, Tables 6 to 9 each show an Example in the case of joining a heat conduction section to a heat-radiating cooling section. Table 6 shows Example 4 in the case that specific materials and dimensions are employed in a stacked structure shown in FIG. 1. Table 7 shows Example 5 in the case that specific materials and dimensions are employed in a stacked structure shown in FIG. 13. Table 8 shows Example 6 in the case that specific materials and dimensions are employed in a stacked structure shown in FIG. 12. Table 9 shows Comparative Example 2 in the case that an article in circulation in the market at present is employed in a stacked structure shown in FIG. 14 serving as a bench mark. Table 10 shows the entire thermal conductivity and thermal resistance, and realizability thereof.

In each of Examples 4 to 6, thermal conductivity is above 200 W/mk, and realizability is 0.97 or more. It is understood that joining was suitably performed so as to have no void (air layer) to serve as thermal resistance. On the other hand, in Comparative Example 2, thermal conductivity is 110 W/mk (practical value), which is about half and prone to have deviations. Also, the realizability is small by the influence of grease.

Table 1 is Example 1 and shows an example with respect to only the thermal conduction sections 5a, 5b of Fig. 1. By describing coefficient of thermal expansion, yield stress, Poisson ratio, longitudinal modulus of elasticity, shear modulus, and the like in the table, it is shown that stress simulation generated in the thermal conduction sections is possible. In Example 1, a surface of the electrode section is plated with Ni for good solderability. The electrode layer has a thickness of 0.1 mm. The thickness is determined in consideration of influence on the electronic circuit where soldering is performed. The thickness of the electrode layer changes depending on a component and thickness of the solder. In the case of copper or a copper alloy, thickness of the electrode layer is suitably 0.05 to 0.5 mm. In the case that the electrode layer is of aluminum or an aluminum alloy, thickness of the electrode layer is suitably 0.05 to 1.0 mm. The reason why an aluminum or aluminum alloy electrode layer is thick is because it is prone to absorb generated stress in the electrode layer because it has low yield stress than those of copper or copper alloy. The insulating layer employs Si₃N₄. Though ALN is superior form the viewpoint of thermal conduction, Si₃N₄ is superior form the viewpoint of strength. Selection is possible depending on simulation of generated stress and a thermal shock resistance test. The intermediate layer employs Cu. Selection for this is also possible from a copper alloy, aluminum, and an aluminum alloy. Thickness of the layer is basically made to match thickness of the electrode section. In the case that circuit is cut by the electrode section, it should be matched with the volume. In Example 1, the intermediate layer with a thickness of 0.3 mm could be used from the relation with a heat sink layer.
The heat sink layer is a composite material obtained by impregnating carbon with metal, and a copper alloy (4% Si) is employed as the metal. With regard to this, various kinds of materials can be selected as described above. Particularly, in the case of a composite material, a joining property between a material with which the base material is impregnated and a base material, control of the remaining pores, etc., are important. Therefore, in the case that, for example, carbon is impregnated with metal to give a composite material, it is also preferable to mix an additive element Si, which can improve a flowability, reduce the remaining pores, form SiC, and improve a joining property. The additive element is selected in consideration of a mutual reaction with the base material, easiness in manufacturing, and the like. In the case that the base material is SiC, pure copper reacts with SiC. Therefore, selection of the additional element is important. The property values in Table 1 are practical values. By a theoretical value for a thermal conduction section obtained from the practical value, the thermal conductivity, thermal resistance, and heat capacity are calculated. The thermal conductivity and the thermal resistance are described with the values obtained by practical measurement as practical values, and a difference between a theoretical value and a practical value is shown as realizability. The realizability is shown as a practical value / a theoretical value for the thermal conductivity, and a theoretical value / a practical value for the thermal resistance.

The heat capacity up to an insulative substrate serves as an index for storing heat generated in an electronic circuit. When a cooling medium flowing in a heat-radiating, cooling body is water, a cold liquid medium, or the like, it is not regarded as important. However, in the case of gas such as air or inert gas, it is important because the heat-taking amount is small. The first blazing material used for joining is an Ag-Cu-In-Ti type and can be adopted for both joining to ceramic and joining of joined metals to a composite material. The first blazing material enables thin and secure joining.

Table 2 is an example of a structure corresponding to FIG. 7. The difference from Example 1 is presence/absence of an under layer, and, with regard to effects of this, comparison can be conducted with thermal conductivity and thermal resistance. Like Example 1, there is little difference between the theoretical values and the practical values, and one manufactured by a method of the present invention shows almost the same measurement results as the theoretical values. This shows that joining thickness by the first blazing material is small and that joining without hindering thermal conduction is realized.

In Example 3 shown in Table 3, stacking order was changed in thermal conduction section. It has a structure shown in FIG. 11. This aims to increase heat capacity up to an insulative substrate. It is understood that an amount of heat capacity which is important when a medium flowing in the heat-radiating cooling section is not liquid but gas (air, inert gas, carbonic acid gas, etc.) is large. Also, in this case, there is little difference from the theoretical values, and it is understood that almost ideal joining was carried out.

Table 4 shows Comparative Example 1 (5e section of FIG. 14), where a stacked structure and its properties of a hybrid car in the present conditions are expected. A substrate where aluminum is disposed on the upside and downside of aluminum nitride is joined to CuMo by soldering and fixed, by a screw clamp, to a heat-radiating, cooling body cooled by water by means of electrically conductive grease. Table 4 shows thermal conductivity and heat capacity up to CuMo. The reason why it has a low realizability in comparison with Example is considered to be because a void is prone to be formed inside in the case of soldering.

Table 5 collectively shows thermal conductivity, thermal resistance, and heat capacity up to a substrate, which are important properties related to Examples 1 to 3 and Comparative Example 4. A theoretical value, a practical value, and a realizability after being joined are shown with evaluating each of the properties from ⓪ for "excellent" to × for "bad". Δ means a "usable range", ○ means a "desirable range", ⓪ means a "more desirable range", and × means that "the aim could not be achieved". In each Example, the thermal conductivity is above 200 W/mK and above 230 W/mK, which is in the more desirable range. Also, the thermal resistance is 0.03 K/W, which is very low and below 0.025 K/W, which is in the more desirable range. Also, the realizability is above 0.95. Thus, it is understood that almost ideal joining can be realized. Though ideal realizability is 100%, it is desirably 0.9 or more, and more desirably 0.95 or more. In all Examples, realizability was 0.95 or more.

Examples 4 to 6 shown in Table 6 show properties after a heat-radiating cooling section was joined. As properties shown, various kinds of values are shown with respect to thermal conduction sections like the above Examples 1 to 3 and Comparative Example 1. Table 6 is a case of Fig. 1. The heat-radiating cooling section is of 10 mm copper and was joined by the use of the second blazing material. The second brazing material is of Ag-Cu-In-Ti type, which is excellent in joinability despite its thinness. The thermal conductivity is above 200 W/mK, and the thermal resistance is 0.12 K/W or less. The thermal conductivity is above 230 W/mK, which is in the more preferable range. The thermal resistance is lower than 0.09 K/W. As also the realizability is high, joining with the heat-radiating cooling section is considered to be good.

Table 7 shows Example 5 and is in the case of Fig. 13. Here, the heat-radiating cooling section is of 10 mm aluminum. The second brazing material used here is a Sn type solder. After the thermal conduction sections 5a, 5b are previously joined, joining with the heat-radiating cooling section is conducted. Since it has a melting point of 200 to 300°C, while the Ag-Cu-In-Ti type used for joining thermal conduction section has a melting point of 700 to 800°C, joining can be performed without influencing joining of the thermal conduction section. This case also satisfies a preferable range of thermal conductivity or thermal resistance.

Table 8 shows Example 6 and is the case of Fig. 12. Here, the thermal conduction section has a different stacked structure. This is for increasing heat capacity up to the insulating layer. Heat-radiating cooling section was joined to the thermal conduction section by the use of the second brazing material used in Example 7. The joining by the second blazing material is performed in the state that the thermal conduction sections are previously joined In this case, pressure is not applied. Of course, it is possible to aim at a thin brazing material layer by applying pressure, and thereby it is possible to raise realizability of thermal conductivity and thermal resistance. Also in this case, a preferable range of thermal conductivity or thermal resistance is satisfied.

Table 9 shows the case of Fig. 14, which is a Comparative Example. It has a structure of fixing with a screw with thermal conduction grease. It has a low theoretical value and low realizability of thermal conductivity. This is because control of presence of a void in the grease and control of thickness of grease are difficult. It can be understood that it has only a half heat transmitting ability in comparison with Examples of the present invention. The heat-radiating cooling section employed 10 mm aluminum.

Table 10 shows comparisons of thermal conductivity and thermal resistance between Examples 4 to 6 and Comparative Example 2. In each of them, evaluations were given as Δ for a "usable range", ○ for a "desirable range", ⓪ for a "further desirable range", × for "aim is not achieved". All the Examples show thermal properties in desirable ranges and have high realizability, which show good joinability.

Table 11 shows results of experiment to check durability of a structure depending on thickness of a heat sink layer in a cooling/heating test. Cooling and heating from -40°C to 150°C were repeated one thousand times in the cooling/heating test. Generation of a crack is the result of observation of an electrically insulating layer, a heat sink layer, a blazing material layer. The structure of Fig. 1 has a structure having the thickness shown in Table 6 except for the heat sink layer. Each of the thermal conductivity and the thermal resistance has a practical value before the test. In the case that the heat sink layer had a thickness of 0.5 mm, a crack was generated. However, when it is 1.5 mm, no crack was generated.

Table 12 shows results of experiment to check durability of a structure depending on thickness of a heat sink layer in a cooling/heating test. The structure of Fig. 13 has a structure having the thickness shown in Table 7 except for the heat sink layer. Each of the thermal conductivity and the thermal resistance has a practical value before the test. In the case that the heat sink layer had a thickness of 0.8 mm, a crack was generated. However, when it is 1.0 mm, no crack was generated.

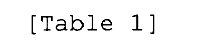

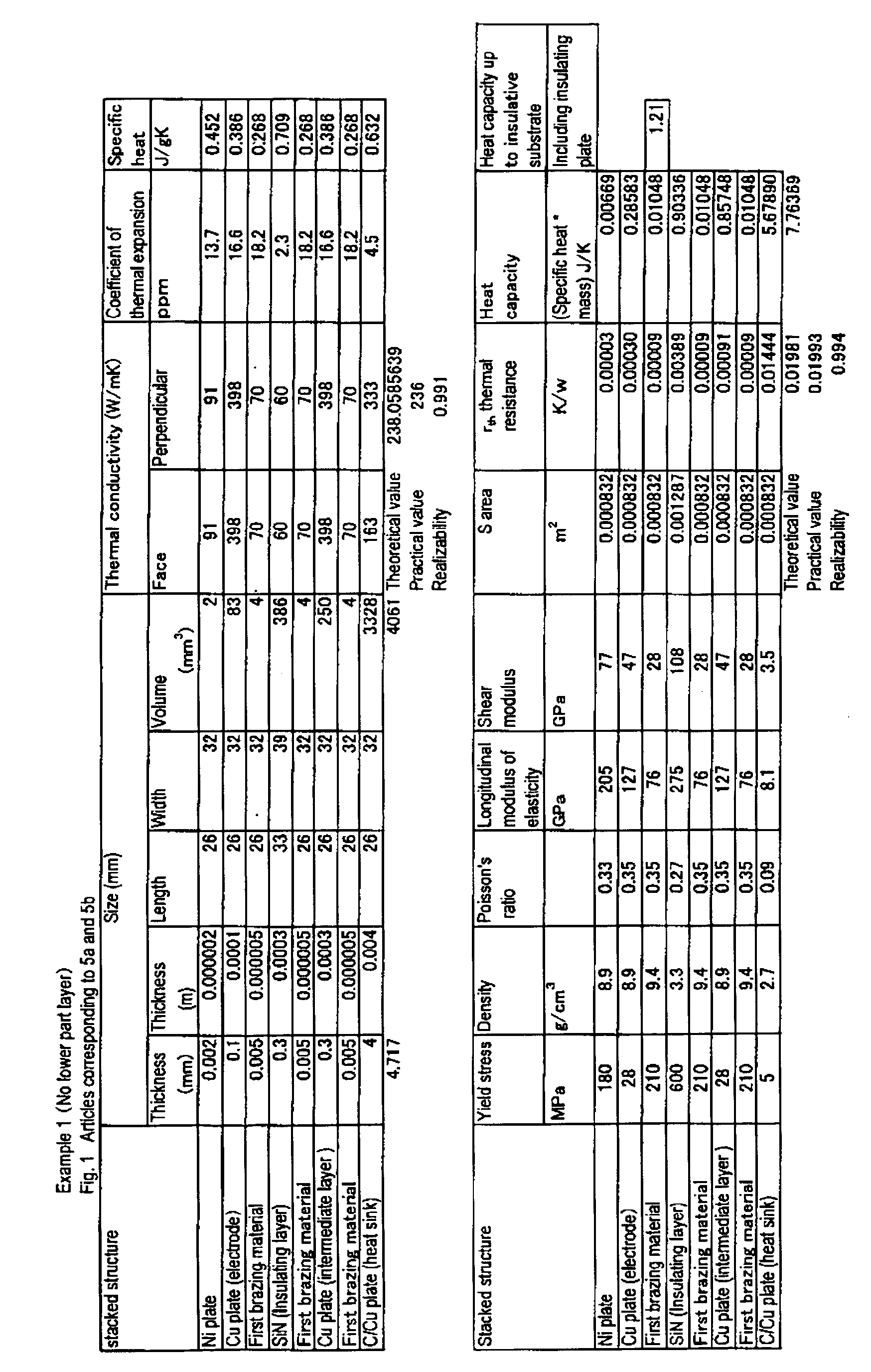

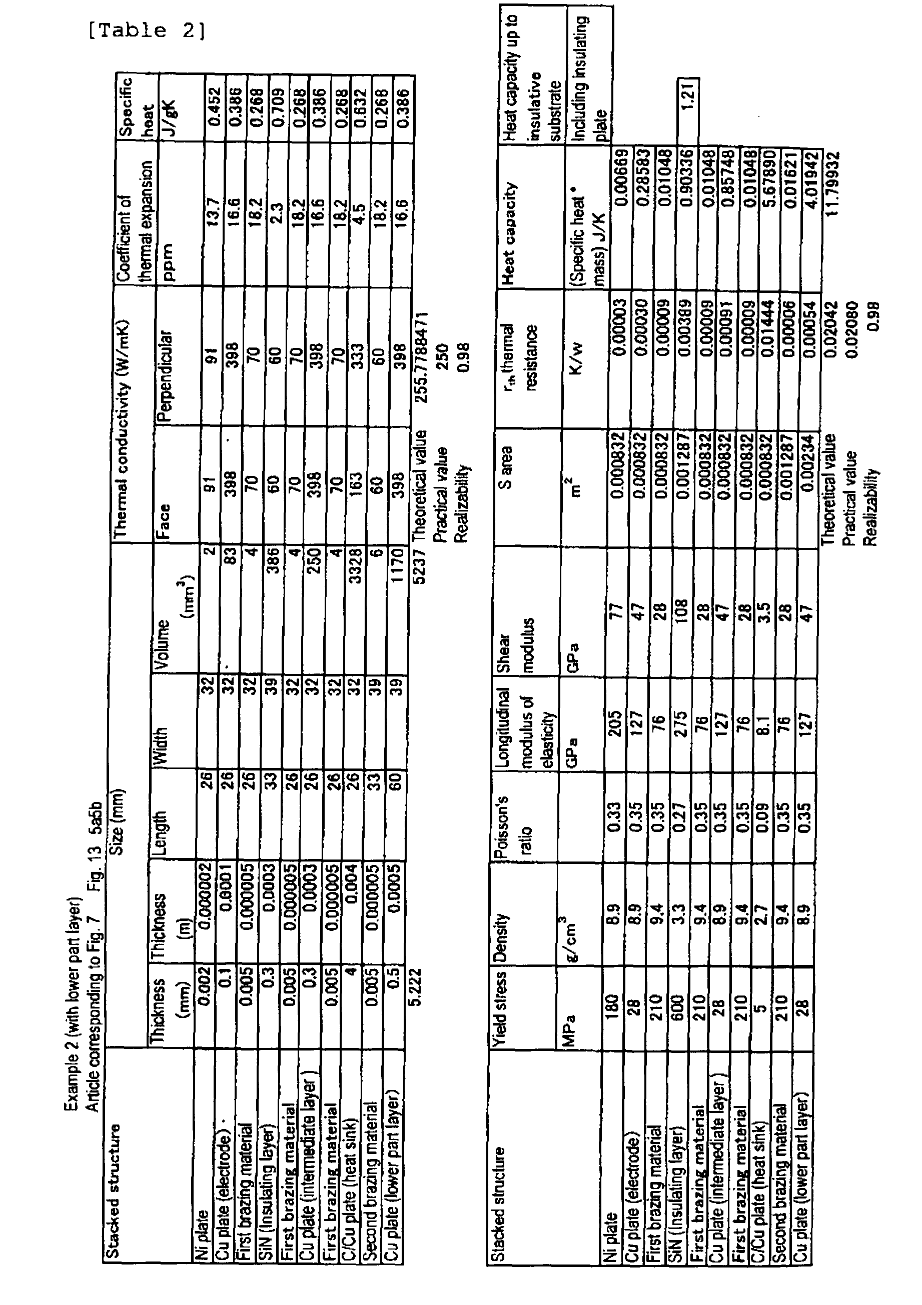

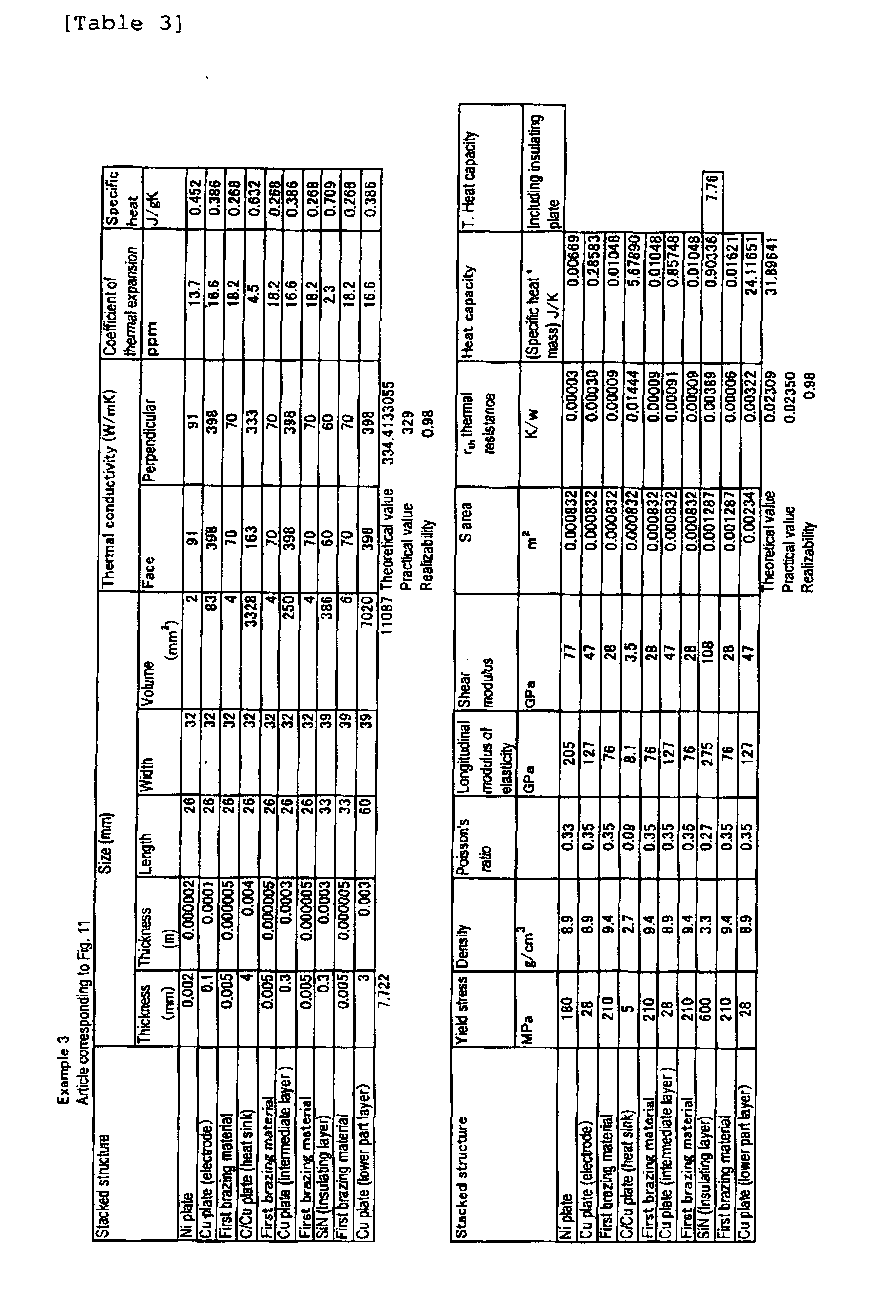

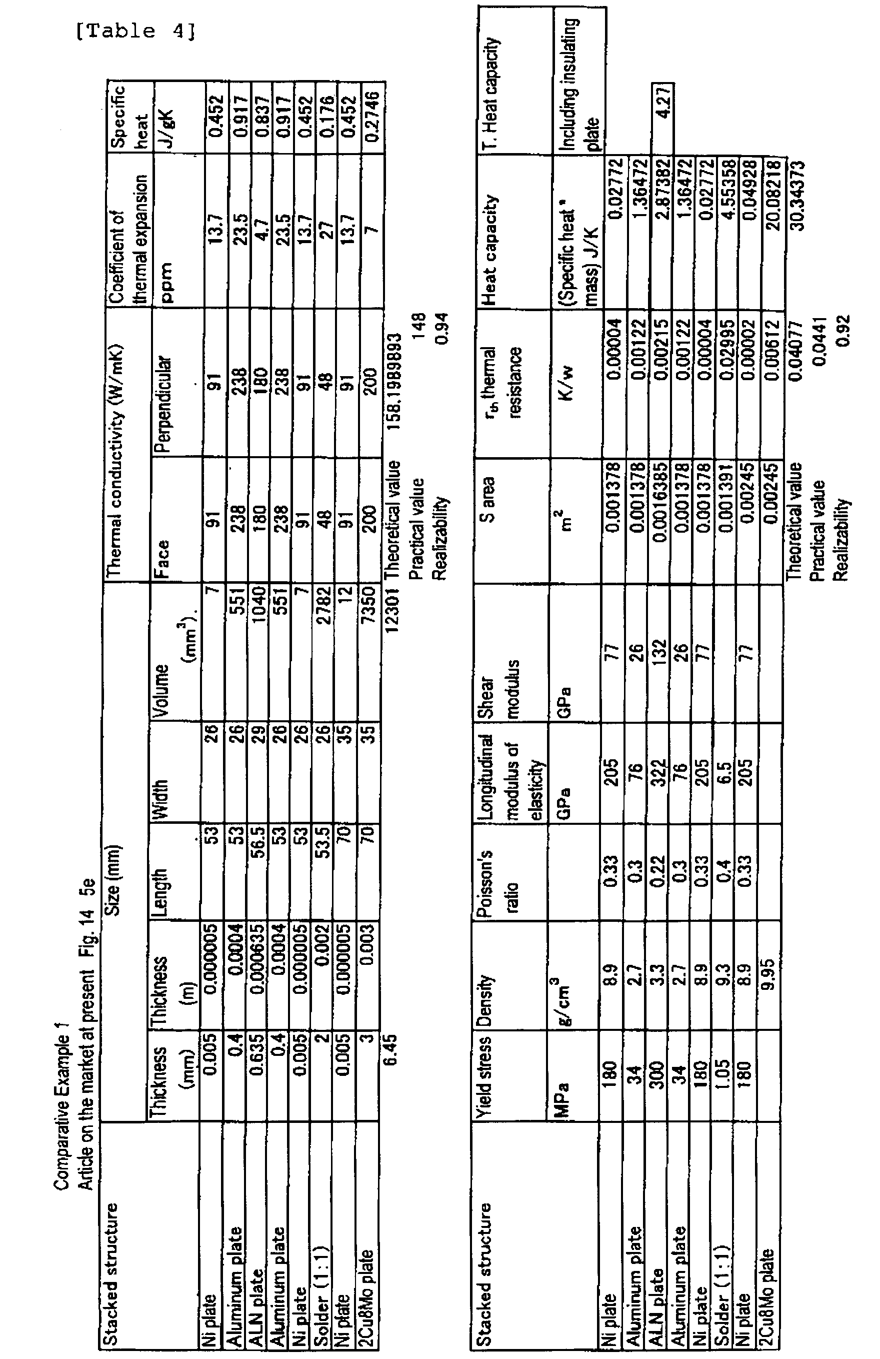

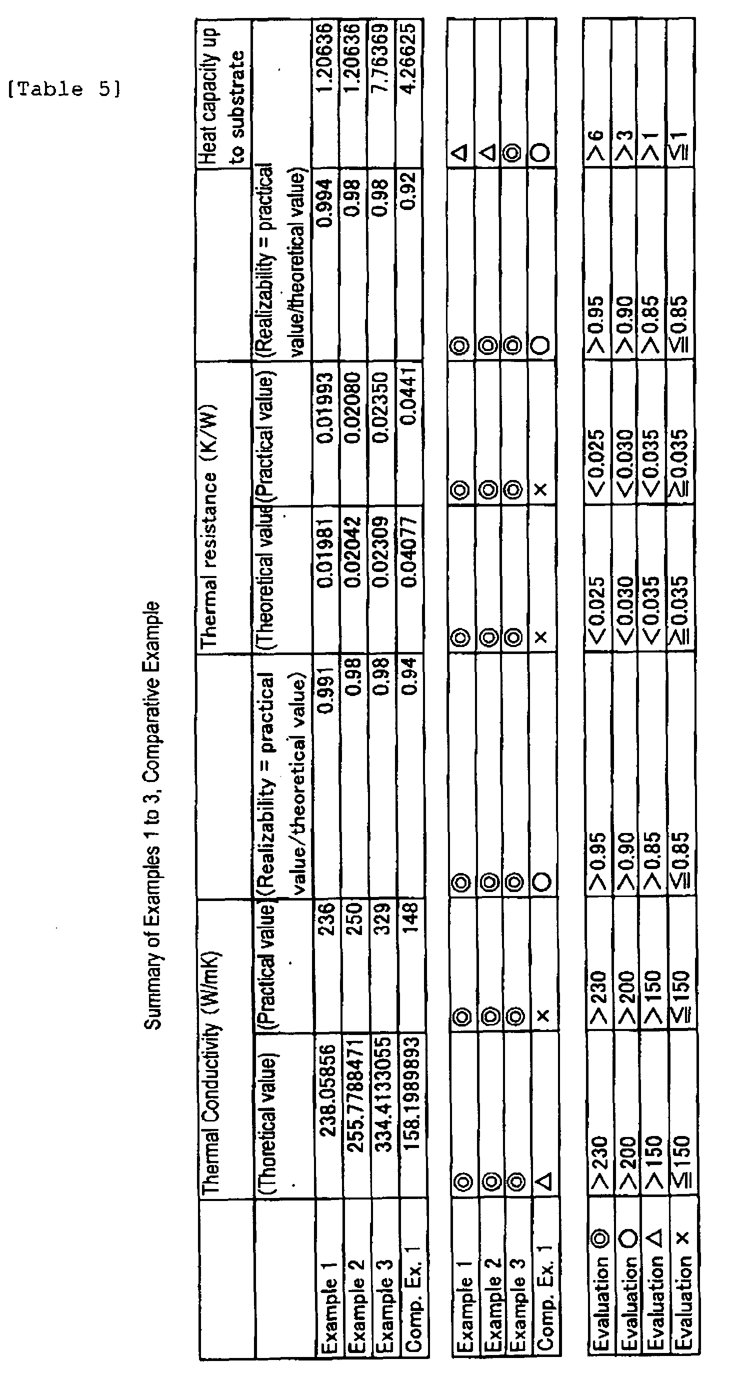

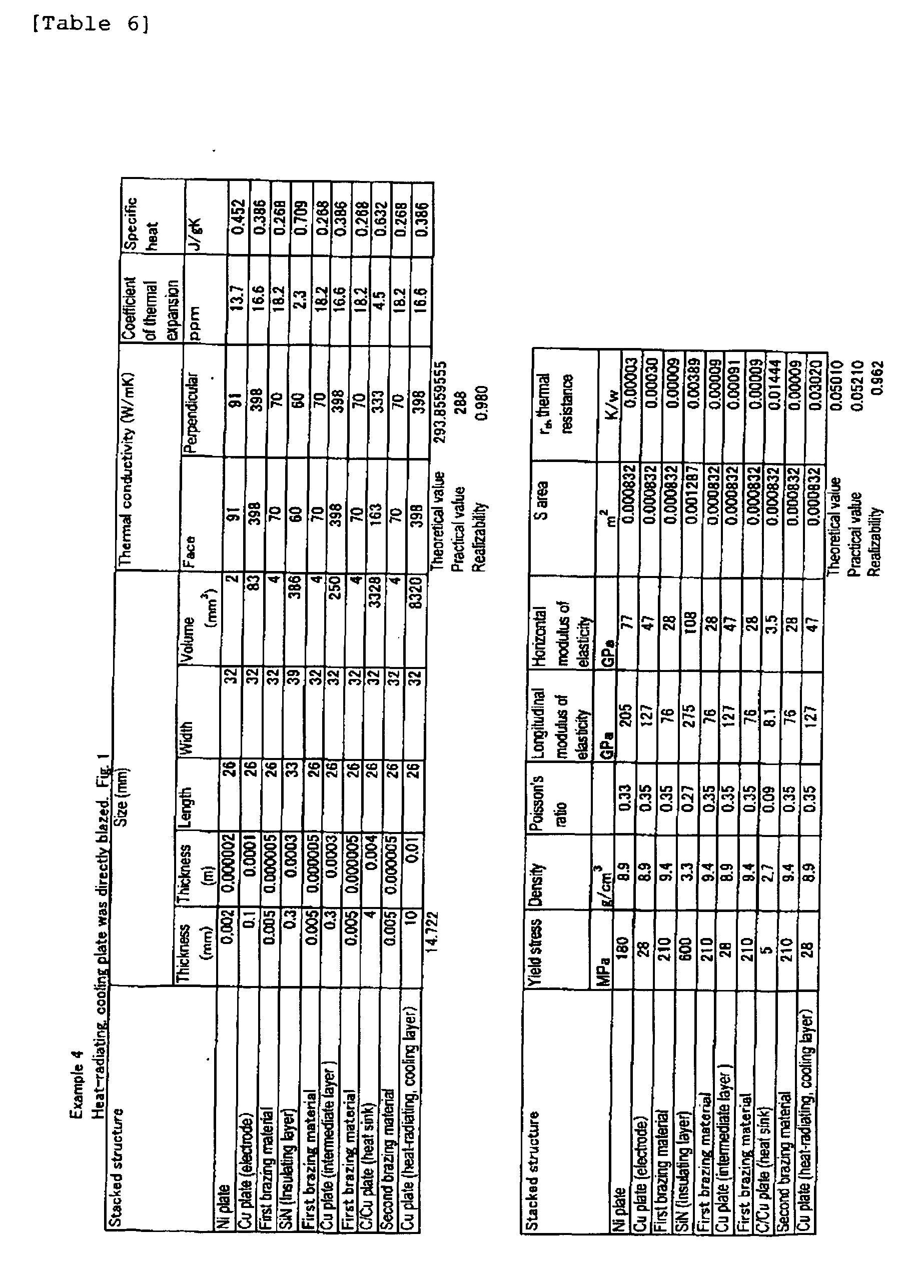

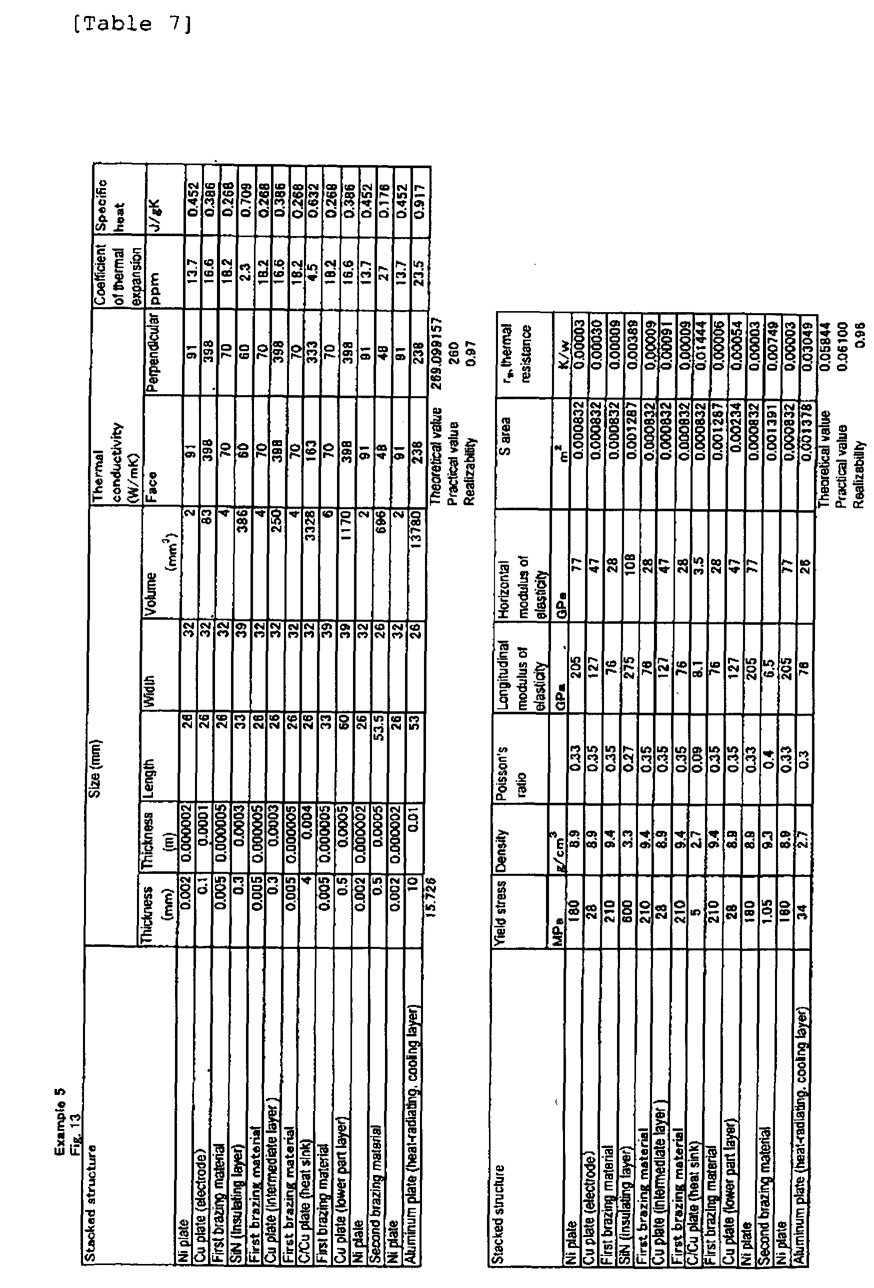

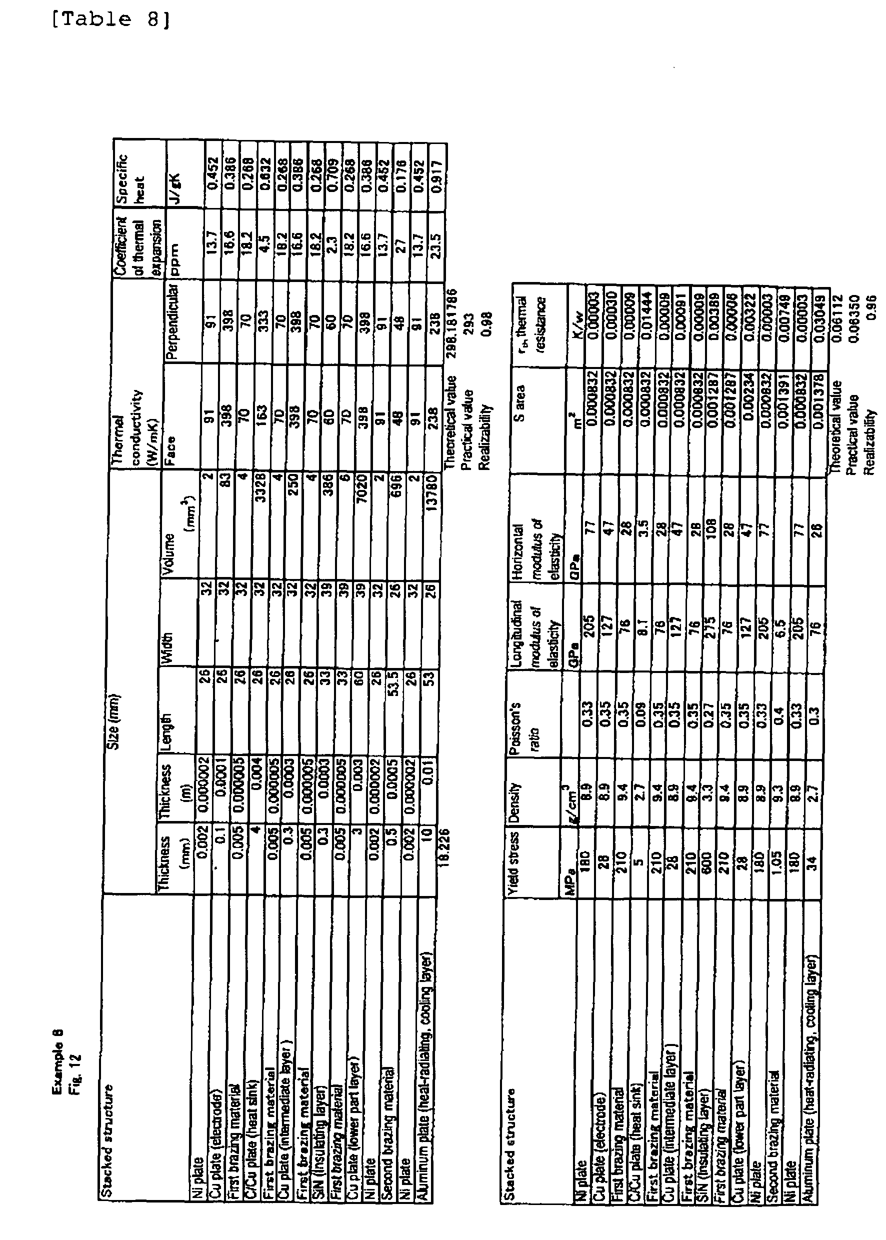

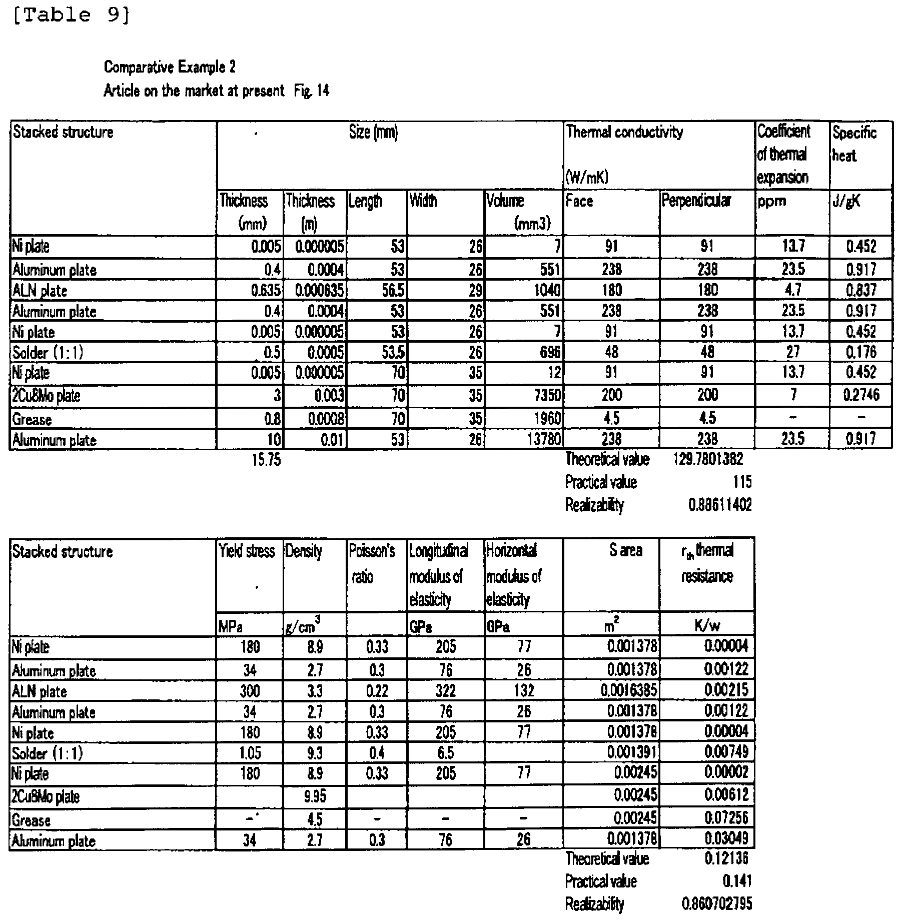

**[Table 10]**

| Examples 6 to 8, Summary of Comparative Example 2 | | | | | | |
|---|---|---|---|---|---|---|
| | Thermal Conductivity (W/mK) | | | Thermal resistance (K/W) | | |
| | (Thoretical value) | (Practical value) | (Realizability =practical value/theoretical value) | (Theoretical value) | (Practical value) | (Realizability = practical value/theoretical value) |
| Example 4 | 293.95596 | 288 | 0.980 | 0.05010 | 0.05210 | 0.962 |
| Example 5 | 269.0991567 | 260 | 0.97 | 0.05844 | 0.06100 | 0.96 |
| Example 6 | 29B.1817862 | 293 | 0.98 | 0.06112 | 0.06350 | 0.96 |
| Comparative Example 2 | 129.7801382 | 115 | 0.89 | 0.12136 | 0.141 | 0.86 |
| | | | | | | |
| Example 4 | ⓪ | ⓪ | ⓪ | ⓪ | ⓪ | ⓪ |
| Example 5 | ⓪ | ⓪ | ⓪ | ⓪ | ○ | ⓪ |
| Example 6 | ⓪ | ⓪ | ⓪ | ○ | ○ | ⓪ |
| Comparative Example 2 | × | × | Δ | × | × | Δ |
| | | | | | | |
| Evaluation ⓪ | > 230 | > 230 | >0.95 | < 0.06 | <0.06 | >0.95 |
| Evaluation ○ | >200 | >200 | >0.90 | <0.09 | <0,09 | >0.90 |
| Evaluation Δ | >150 | >150 | >0.85 | <0.12 | <0.12 | >0.85 |
| Evaluation × | ≦150 | ≦150 | ≦0.85 | ≧0.12 | ≧0.12 | ≦0.85 |

**[Table 11]**

| Summary of reliability test 2 | | | | |
|---|---|---|---|---|
| Case of Fig. 1 | Heat sink | Thermal conductivity (W/mK) | Thermal resistance (K/W) | Crack after cooling/ heating test |
| Structure of Table 6 | Layer thickness (mm) | (Practical value) | (Practical value) | |
| Reliability test 1 | 20 | 280 | 0.11000 | None |
| Reliability test 2 | 5 | 288 | 0.05500 | None |
| Reliability test 3 | 1.5 | 291 | 0.04250 | None |
| Reliabilty test 4 | 0.5 | 295 | 0.03850 | Present |

**[Table 12]**

| Summary of reliability test 2 | | | | |
|---|---|---|---|---|
| Case of Fig. 13 | Heat sink | Thermal conductivity (W/mK) | Thermal resistance (K/W) | Crack after cooling/ heating test |
| Structure of Table 7 | Layer thickness (mm) | (Practical value) | (Practical value) | |
| Reliability test 1 | 10 | 266 | 0.08300 | None |
| Reliability test 2 | 5 | 264 | 0.06480 | None |
| Reliability test 3 | 1 | 260 | 0,04980 | None |
| Reliabilty test 4 | 0.8 | 260 | 0.04900 | Present |

Next, an embodiment of an electronic component of the present invention will be described. As shown in FIG. 1, the electronic component 11 of the present embodiment is configured such that electronic circuit chips (IC chips 100) are disposed on the respective electrode layers 4 of the two or more heat conduction sections 5a and 5b of the heat sink module 10 of an embodiment of the present invention via respective solder layers 110. That is, the electronic component 11 of the present embodiment is configured by the use of the heat sink module 10. Accordingly, the electronic component 11 exhibits good heat conduction, is unlikely to suffer separation, cracking, or a like problem of component members, and provides excellent reliability.

The electronic component 11 is configured such that a single heat-radiating cooling section 7 allows two or more IC chips 100 to be disposed thereon. Accordingly, while exhibiting sufficiently high heat radiation, the electronic component 11 implements a small size and is thus space-saving. Thus, the electronic component 11 of the present embodiment is favorably applicable to, for example, a CPU for use in an AC/DC conversion module and a current flow-rate adjustment mechanism of a hybrid vehicle, a computer, and a server.

A conventionally known method may be used for disposing electronic circuit chips (IC chips 100) on the respective electrode layers 4 of the two or more heat conduction sections 5a and 5b of the heat sink module 10. Specifically, the IC chips 100 are disposed and fixed via the respective solder layers 110. Preferably, for example, an Ni layer is interposed between the IC chip 100 and the solder layer 110, since the Ni layer improves wettability between the IC chip 100 and the solder layer 110 to thereby impart excellent reliability to the electronic component 11. Preferably, the solder layer 110 is of lead-free solder, since environmental load can be reduced.

### Industrial Applicability

The heat sink module and the electronic component of the present invention are favorably applicable to, for example, a CPU for use in an AC/DC conversion module and a current flow-rate adjustment mechanism of a hybrid vehicle, a computer, and a server.

## Claims

1. A heat sink module comprising:
two or more heat conduction sections, each comprising a heat sink layer formed from a heat sink material having a coefficient of thermal expansion of 1 × 10⁻⁶/K to 8 × 10⁻⁶/K, an intermediate layer formed from Cu, a Cu alloy, Al, or an Al alloy, an electrically insulating layer, and an electrode layer formed from Cu, a Cu alloy, Al, or an Al alloy, and the heat sink layer, the intermediate layer, the electrically insulating layer, and the electrode layer being joined together in layers by means of a first brazing material; and
a heat-radiating cooling section having two or more seat surfaces;
wherein at least the seat surfaces of the heat-radiating cooling section are formed from Cu, a Cu alloy, Al, or an Al alloy;
the two or more heat conduction sections are joined, by means of a second brazing material, to the corresponding two or more seat surfaces of the heat-radiating cooling section with a state that each of the heat sink layers is disposed on each seat surfaces; and
the heat-radiating cooling section includes a flow path through which a cooling medium flows.

2. A heat sink module according to claim 1, wherein a surface or a bonding face with the second blazing material of the electrode layer is plated with Ni for good solderability.

3. A heat sink module comprising:
two or more heat conduction sections, each comprising a heat sink layer formed from a heat sink material having a coefficient of thermal expansion of 1 × 10⁻⁶/K to 8 × 10⁻⁶/K, an intermediate layer formed from Cu, a Cu alloy, Al, or an Al alloy, an electrically insulating layer, an electrode layer formed from Cu, a Cu alloy, Al, or an Al alloy, and an under layer formed from Cu, a Cu alloy, Al, or an Al alloy, and the heat sink layer, the intermediate layer, the electrically insulating layer, the electrode layer, and the under layer being joined together in layers by means of a first brazing material; and
a heat-radiating cooling section having two or more seat surfaces;
wherein at least the seat surfaces of the heat-radiating cooling section are formed from Cu, a Cu alloy, Al, or an Al alloy;
the two or more heat conduction sections are joined, by means of a second brazing material, to the corresponding two or more seat surfaces of the heat-radiating cooling section with a state that each of the heat sink layers thereof is disposed on the respective seat surfaces; and
the heat-radiating cooling section includes a flow path through which a cooling medium flows.

4. A heat sink module according to claim 3, wherein at least one of a surface of the electrode layer and a surface of the under layer is plated with Ni for good solderability.

5. A heat sink module according to claim 2 or 4, wherein the Ni plate has a thickness of 2 µm or more.

6. A heat sink module according to any one of claims 1 to 5, wherein the heat conduction sections have a thermal conductivity of above 200 W/mK or a thermal resistance of 0.03 K/W or less, and the heat conduction sections have a thermal conductivity of above 200 W/mK or a thermal resistance of 0.12 K/W or less in a portion including a heat-radiating, cooling plate (portion up to a shortest distance to the cooling medium).

7. A heat sink module according to any one of claims 1 to 5, wherein the heat conduction sections have a thermal conductivity of above 230 W/mK or a thermal resistance of 0.025 K/W or less, and the heat conduction sections have a thermal conductivity of above 230 W/mK or a thermal resistance of 0.09 K/W or less in a portion including a heat-radiating, cooling plate (portion up to a shortest distance to the Cooling medium).

8. A heat sink module according to any one of claims 1 to 7, wherein the heat sink layers of the heat conduction sections have a thickness of 1mm or more, and each of the heat conduction sections has a volume of 12000 mm³ or less.

9. A heat sink module according to claim any one of claims 1 to 8, wherein the flow path of the heat-radiating cooling section has an inner wall surface assuming the form of recesses and projections.

10. A heat sink module according to any one of claims 1 to 9, wherein a meshy member is disposed in the flow path of the heat-radiating cooling section.

11. A heat sink module according to any one of claims 1 to 10, wherein the heat sink material is a material comprising SiC, Si₃N₄, AlN, BeO, BN, or C or a composite material obtained by impregnating a base material of SiC, Si₃N₄, AlN, BeO, BN, or C with Cu, a Cu alloy, Al, or an Al alloy.

12. A heat sink module according to claim 11, wherein the base material is a porous body.

13. A heat sink module according to any one of claims 1 to 12, wherein the first brazing material and the second brazing material contain one or more elements belonging to Group 2A, 3A, 4A, 5A, or 4B of the Periodic Table.

14. A heat sink module according to any one of claims 1 to 13, wherein the electrically insulating layer is formed from AlN or Si₃N₄.

15. A heat sink module according to any one of claims 1 to 14, wherein portions of the heat-radiating cooling section associated with the seat surfaces each have a thin-walled portion and a thick-walled portion; and
the thin-walled portion has a thickness of 0.1 mm or more.

16. A method of manufacturing a heat sink module, comprising the steps of:
forming two or more heat conduction sections, each being formed by joining together in layers, by means of a first brazing material, a heat sink layer formed from a heat sink material having a coefficient of thermal expansion of 1 × 10⁻⁶/K to 8 × 10⁻⁶/K, an intermediate layer formed from Cu, a Cu alloy, Al, or an A1 alloy, an electrically insulating layer, and an electrode layer formed from Cu, a Cu alloy, A1, or an A1 alloy; and
joining, by means of a second brazing material, the two or more heat conduction sections to a heat-radiating cooling section which has two or more seat surfaces, in which at least the seat surfaces are formed from Cu, a Cu alloy, Al, or an Al alloy, and which includes a flow path through which a cooling medium flows; with a state that each of the heat sink layers is disposed on the corresponding two or more seat surfaces.

17. A method of manufacturing a heat sink module according to claim 16, wherein a surface of the electrode layer is plated with Ni for good solderability.

18. A method of manufacturing a heat sink module, comprising the steps of:
forming two or more heat conduction sections, each being obtained by joining together in layers, by means of a first brazing material, a heat sink layer formed from a heat sink material having a coefficient of thermal expansion of 1 × 10⁻⁶/K to 8 × 10⁻⁶/K, an intermediate layer formed from Cu, a Cu alloy, Al, or an Al alloy, an electrically insulating layer, an electrode layer formed from Cu, a Cu alloy, Al, or an Al alloy, and an under layer formed from Cu, a Cu alloy, A1, or an Al alloy; and
joining, by means of a second brazing material, the two or more heat conduction sections to a heat-radiating cooling section which has two or more seat surfaces, in which at least the seat surfaces are formed from Cu, a Cu alloy, Al, or an Al alloy, and which includes a flow path through which a cooling medium flows; with a state that each of the heat sink layers of the heat conduction sections is disposed on the corresponding two or more seat surfaces.

19. A method of manufacturing a heat sink module according to claim 18, wherein at least one of a surface of the electrode layer and a surface of the under layer is plated with Ni for good solderability.

20. A method of manufacturing a heat sink module according to claim 17 or 19, wherein the Ni plate has a thickness of 2 µm or more.

21. A method of manufacturing a heat sink module according to any one of claims 16 to 20, wherein the heat conduction sections have a thermal conductivity of above 200 W/mK or a thermal resistance of 0.03 K/W or less, and the heat conduction sections have a thermal conductivity of above 200 W/mK or a thermal resistance of 0.12 K/W or less in a portion including a heat-radiating, cooling plate (portion up to a shortest.distance to the cooling medium).

22. A method of manufacturing a heat sink module according to any one of claims 16 to 20, wherein the heat conduction sections have a thermal conductivity of above 230 W/mK or a thermal resistance of 0.025 K/W or less, and the heat conduction sections have a thermal conductivity of above 230 W/mK or a thermal resistance of 0.09 K/W or less in a portion including a heat-radiating, cooling plate (portion up to a shortest distance to the cooling medium).

23. A method of manufacturing a heat sink module according to any one of claims 16 to 20, wherein the heat sink layers of the heat conduction sections have a thickness of 1mm or more, and each of the heat conduction sections has a volume of 12000 mm³ or less.

24. A method of manufacturing a heat sink module according to any one of claims 16 to 23, wherein the first brazing material and the second brazing material contain one or more elements belonging to Group 2A, 3A, 4A, 5A, or 4B of the Periodic Table.

25. A method of manufacturing a heat sink module according to any one of claims 16 to 24, further comprising the step of arranging a plurality of plate-like members in layers and joining the plate-like members together by means of a third brazing material'so as to yield the heat-radiating cooling section having a flow path formed therein through which a cooling medium flows.

26. A method of manufacturing a heat sink module according to claim 25, wherein, among the plate-like members, the plate-like members other than those encompassing the seat surfaces are lower in coefficient of thermal expansion than those encompassing the seat surfaces.

27. A method of manufacturing a heat sink module according to any one of claims 16 to 26, wherein the heat sink material is a material comprising SiC, Si₃N₄, AlN, BeO, BN, or C or a composite material obtained by impregnating a base material of SiC, Si₃N₄, AlN, BeO, BN, or C with Cu, a Cu alloy, A1, or an A1 alloy.

28. A method of manufacturing a heat sink module according to claim 27, wherein the base material is a porous body.

29. A method of manufacturing a heat sink module according to any one of claims 16 to 28, wherein the electrically insulating layer is formed from AlN or Si₃N₄.

30. A method of manufacturing a heat sink module according to claim 29, wherein insulation ability is secured by subjecting a surface of the electrically insulating layer formed from A1N or Si₃N₄ to a blasting or etching treatment.

31. An electronic component wherein two or more electronic circuit chips are disposed, via respective solder layers, on the respective electrode layers of the two or more heat conduction sections of the heat sink module according to any one of claims 1 to 15.

32. An electronic component according to claim 31, wherein the solder layers are made of lead-free solder.
